# EUROPEAN PATENT APPLICATION

(11) **EP 2 626 906 A2**
(43) Date of publication of application: **14.08.2013**
(21) Application number: 13153523.9
(22) Date of filing: 31.01.2013
(51) Int. Cl.: H01L 29/739, H01L 21/331, H01L 29/06, H01L 21/20

(54) **Semiconductor device**

(30) Priority: 09.02.2012 JP 2012026642; 14.09.2012 JP 2012202223
(71) Applicant: Renesas Electronics Corporation, Kanagawa 211-8668 (JP)
(72) Inventor: Arai, Daisuke, Kanagawa 211-8668 (JP); Kubo, Sakae, Kanagawa 211-8668 (JP); Ikegami, Yuta, Kanagawa 211-8668 (JP)
(74) Representative: Calderbank, Thomas Roger

(57) **Abstract**

To improve a manufacture yield of semiconductor devices each including an 1GBT, an active region is defined by an insulating film and where an element of an 1GBT is formed has a first long side and a second long side spaced at a predetermined distance apart from each other and extended in a first direction in a planar view. One end of the first long side has a first short side forming a first angle with the first long side, and one end of the second long side has a second short side forming a second angle with the second long side. The other end of the first long side has a third short side forming a third angle with the first long side, and the other end of the second long side has a fourth short side forming a fourth angle with the second long side. The first angle, the second angle, the third angle, and the fourth angle are in a range larger than 90 degrees and smaller than 180 degrees.

## Description

The present invention relates to a semiconductor device, and it can be suitably used for a semiconductor device including a planar-gate-type IGBT (Insulated Gate Bipolar Transistor).

In an IGBT, a surface semiconductor layer is formed by an epitaxial method on a main surface (a front surface) of a base layer made of single crystal silicon via a buried insulating film. A source layer, a channel layer, and an emitter layer (a back gate layer) are formed on this surface semiconductor layer. The base layer and the surface semiconductor layer are connected through an opening (a separating part) formed in the buried insulating film. Also, a plurality of active regions are defined on the main surface of the base layer each having an insulating film that is thicker than the buried insulating film, and the surface semiconductor layer is formed in each of the plurality of active regions.

For example, Japanese Patent Application Laid-Open Publication No. 9-36042 (Patent Document 1) describes a method of performing single-crystallization of an amorphous semiconductor layer by using a (100) equivalent plane as a seed portion (a seed crystal portion) by an SPE (solid-phase epitaxial growth) method to make a single crystal layer on an insulating film. Patent Document 1 discloses technology by which, with a plane pattern of the seed portion being taken as a pattern surrounding a predetermined region of the amorphous semiconductor layer, the predetermined region of the amorphous semiconductor layer surrounded by the seed portion is subjected to single-crystallization by the SPE method to form a desired semiconductor single crystal layer.

Also, Japanese Patent Application Laid-Open Publication No. 63-281418 (Patent Document 2) discloses technology by which, in a method of forming an SOI (Silicon On Insulator) structure using solid phase growth, patterning is performed on an insulating film in a (110) direction to make a seed crystal as having a recessed L shape or a shape obtained by combining the recessed L shapes.

When single crystal silicon forming a surface semiconductor layer is formed by the epitaxial method, a part of the active region is not filled with the single crystal silicon to cause a gap. If this gap is left standing and the single crystal silicon except for that in the active region is removed by, for example, CMP (Chemical Mechanical Polishing), contamination or a foreign substance may occur. Moreover, when a photoresist film is patterned by photolithography in a subsequent process, irregular light reflection due to this gap may occur, thereby making it impossible to form a desired resist pattern. As a result, manufacturing yield of semiconductor devices each including an IGBT is disadvantageously lowered.

The above and other preferred aims and novel characteristics of the present invention will be apparent from the description of the present specification and the accompanying drawings.

According to an embodiment, an active region defined by an insulating film has a first long side and a second long side spaced a predetermined distance apart from each other to extend in a first direction in a planar view. One end of the first long side has a first short side forming a first angle with the first long side, and one end of the second long side has a second short side forming a second angle with the second long side. On the other end of the first long side has a third short side forming a third angle with the first long side, and the other end of the second long side has a fourth short side forming a fourth angle with the second long side. The first angle, the second angle, the third angle, and the fourth angle are in a range larger than 90 degrees and smaller than 180 degrees.

According to an embodiment, manufacture yield of semiconductor devices each including an IGBT can be increased.

### In the drawings:

FIG. 1A is a plan view of main parts of a semiconductor chip in which an IGBT is formed, according to a first embodiment, that is, a plan view of main parts illustrating, in an active portion, a region where an element of the IGBT is formed is partially enlarged;
FIG. 1B is a plan view of main parts illustrating only the region where an element of the IGBT is formed being further enlarged;
FIG. 2 is a plan view of main parts illustrating the active portion and a peripheral portion of the semiconductor chip in which the IGBT is formed according to the first embodiment, that is, a plan view of the main parts in which the active portion corresponds to a cross section along an A-A' line illustrated in FIG. 1B);
FIG. 3 is a plan view of the main parts illustrating the active portion and the peripheral portion of the semiconductor chip in a process of manufacturing a semiconductor device including the IGBT, according to the first embodiment, that is, a plan view of the main parts in which the active portion corresponds to the cross section along the A-A' line illustrated in FIG. 1B;
FIG. 4 is a plan view of the main parts of the same portions as those of FIG. 3 during the process of manufacturing the semiconductor device, continued from FIG. 3;
FIG. 5 is a plan view of the main parts of the same portions as those of FIG. 3 during the process of manufacturing the semiconductor device, continued from FIG. 4;
FIG. 6 is a plan view of the main parts of the same portions as those of FIG. 3 during the process of manufacturing the semiconductor device, continued from FIG. 5;
FIG. 7 is a plan view of the main parts of the same portions as those of FIG. 3 during the process of manufacturing the semiconductor device, continued from FIG. 6;
FIG. 8A is a plan view of main parts of the semiconductor chip during the process of manufacturing the semiconductor device, continued from FIG. 6;
FIG. 8B is a plan view of main parts illustrating only the region where an element of the IGBT is formed in FIG. 8A being further enlarged;
FIG. 9 is a cross-sectional view of main parts of the same portions as those of FIG. 3 during the process of manufacturing the semiconductor device, continued from FIG. 7 and FIG. 8A;
FIG. 10A is a plan view of the main parts of the semiconductor chip during the process of manufacturing the semiconductor device, continued from FIG. 7 and FIG. 8A;
FIG. 10B is a plan view of the main parts illustrating only the region where an element of the IGBT is formed in FIG. 10A being further enlarged;
FIG. 11A is a perspective view of main parts illustrating a part of the active portion of the semiconductor chip, that is, one end of an active region where an element of the IGBT is formed, during the process of manufacturing the semiconductor device being partially enlarged, continued from FIG. 7 and FIG. 8A;
FIG. 11B is a plan view of the main parts illustrating a part of the active portion of the semiconductor chip, that is, one end of the active region where the element of the IGBT is formed, during the process of manufacturing the semiconductor device being partially enlarged, continued from FIG. 7 and FIG. 8A;
FIG. 12 is a cross-sectional view of main parts of the same portions as those of FIG. 3 during the process of manufacturing the semiconductor device, continued from FIG. 9 to FIG. 11B;
FIG. 13A is a plan view of main parts of the semiconductor chip during the process of manufacturing the semiconductor device, continued from FIG. 9 to FIG. 11B;
FIG. 13B is a plan view of the main parts illustrating only the region where an element of the IGBT is formed in FIG. 13A being further enlarged;
FIG. 14A is a perspective view of main parts illustrating a part same as that of FIG. 11A and FIG. 11B, during the process of manufacturing the semiconductor device, continued from FIG. 9 to FIG. 11B;
FIG. 14B is a plan view of the main parts illustrating a part same as that of FIG. 11A and FIG. 11B, during the process of manufacturing the semiconductor device, continued from FIG. 9 to FIG. 11B;
FIG. 15 is a cross-sectional view of main parts of the same portions as those of FIG. 3 during the process of manufacturing the semiconductor device, continued from FIG. 12 to FIG. 14B;
FIG. 16A is a plan view of main parts of the semiconductor chip during the process of manufacturing the semiconductor device, continued from FIG. 12 to FIG. 14;
FIG. 16B is a plan view of the main parts illustrating a part same as that of FIG. 11A and FIG. 11B, during the process of manufacturing the semiconductor device, continued from FIG. 12 to FIG. 14B;
FIG. 17 is a cross-sectional view of main parts of the same portions as those of FIG. 3 during the process of manufacturing the semiconductor device, continued from FIG. 15 to FIG. 16B;
FIG. 18 is a cross-sectional view of main parts of the same portions as those of FIG. 3 during the process of manufacturing the semiconductor device, continued from FIG. 17;
FIG. 19A is a plan view of main parts of the semiconductor chip during the process of manufacturing the semiconductor device, continued from FIG. 17;
FIG. 19B is a plan view of the main parts illustrating only the region where an element of the IGBT is formed in FIG. 19A being further enlarged;
FIG. 20 is a cross-sectional view of main parts of the same portions as those of FIG. 3 during the process of manufacturing the semiconductor device, continued from FIG. 18 and FIG. 19A;
FIG. 21A is a plan view of main parts of the semiconductor chip during the process of manufacturing the semiconductor device, continued from FIG. 18 and FIG. 19A;
FIG. 21B is a plan view of the main parts illustrating only the region where an element of the IGBT is formed in FIG. 21A being further enlarged;
FIG. 22 is a cross-sectional view of main parts of the same portions as those of FIG. 3 during the process of manufacturing the semiconductor device, continued from FIG. 20 and FIG. 21A;
FIG. 23 is a cross-sectional view of main parts of the same portions as those of FIG. 3 during the process of manufacturing the semiconductor device, continued from FIG. 22;
FIG. 24 is a cross-sectional view of main parts of the same portions as those of FIG. 3 during the process of manufacturing the semiconductor device, continued from FIG. 23;
FIG. 25A is a plan view of main parts of the semiconductor chip during the process of manufacturing the semiconductor device, continued from FIG. 23;
FIG. 25B is a plan view of the main parts illustrating only the region where an element of the IGBT is formed in FIG. 25A being further enlarged;
FIG. 26 is a cross-sectional view of main parts of the same portions as those of FIG. 3 during the process of manufacturing the semiconductor device, continued from FIG. 24 and FIG. 25A;
FIG. 27 is a cross-sectional view of main parts of the same portions as those of FIG. 3 during the process of manufacturing the semiconductor device, continued from FIG. 26;
FIG. 28 is a cross-sectional view of main parts of the same portions as those of FIG. 3 during the process of manufacturing the semiconductor device, continued from FIG. 27;
FIG. 29 is a cross-sectional view of main parts of the same portions as those of FIG. 3 during the process of manufacturing the semiconductor device, continued from FIG. 28;
FIG. 30A is a plan view of main parts of the semiconductor chip during the process of manufacturing the semiconductor device, continued from FIG. 28;
FIG. 30B is a plan view of the main parts illustrating only the region where an element of the IGBT is formed in FIG. 30A being further enlarged;
FIG. 31 is a cross-sectional view of main parts of the same portions as those of FIG. 3 during the process of manufacturing the semiconductor device, continued from FIG. 29 and FIG. 30A;
FIG. 32 is a cross-sectional view of main parts of the same portions as those of FIG. 3 during the process of manufacturing the semiconductor device, continued from FIG. 31;
FIG. 33 is a cross-sectional view of main parts of the same portions as those of FIG. 3 during the process of manufacturing the semiconductor device, continued from FIG. 32;
FIG. 34A is a plan view of main parts of the semiconductor chip during the process of manufacturing the semiconductor device, continued from FIG. 32;
FIG. 34B is a plan view of the main parts illustrating only the region where an element of the IGBT is formed in FIG. 34Abeing further enlarged;
FIG. 35 is a cross-sectional view of main parts of the same portions as those of FIG. 3 during the process of manufacturing the semiconductor device, continued from FIG. 33 and FIG. 34A;
FIG. 36 is a plan view of main parts illustrating a part of the active portion of the semiconductor chip in which the IGBT is formed, that is, one end of an active region where an element of the IGBT is formed, during the process of manufacturing the semiconductor device being partially enlarged;
FIG. 37A is a plan view of main parts illustrating the active portion formed in the semiconductor chip according to the first embodiment;
FIG. 37B is a plan view of main parts illustrating a part of the active region formed around the active portion according to the first embodiment, that is, a region in which an emitter layer to which a source lead electrode is electrically connected, the part being enlarged;
FIG. 38 is a plan view of main parts illustrating a part of the active portion of the semiconductor chip in which the IGBT is formed, that is, the active region in which the element of the IGBT is formed, the part being enlarged;
FIG. 39A is a perspective view of main parts illustrating a part of the active portion of the semiconductor chip studied by the inventors of the present invention, that is, one end of an active region where an element of the IGBT is formed;
FIG. 39B is a plan view of the main parts illustrating a part of the active portion of the semiconductor chip studied by the inventors of the present invention, that is, one end of an active region where an element of the IGBT is formed;
FIG. 40A is a perspective view of main parts illustrating the same part as FIG. 39A of the semiconductor device during the manufacturing process, continued from FIG. 39A and FIG. 39B;
FIG. 40B is a plan view of main parts illustrating the same part as FIG. 39B of the semiconductor device during the manufacturing process, continued from FIG. 39A and FIG. 39B;
FIG. 41A is a perspective view of main parts illustrating the same part as FIG. 39A of the semiconductor device during the manufacturing process, continued from FIG. 40A and FIG. 40B;
FIG. 41B is a plan view of main parts illustrating the same part as FIG. 39B of the semiconductor device during the manufacturing process, continued from FIG. 40A and FIG. 40B;
FIG. 42 is a plan view of main parts illustrating an active region formed in a semiconductor chip according to a second embodiment;
FIG. 43 is a plan view of main parts illustrating a part of the active region formed in an outer periphery portion ofthe semiconductor chip according to the second embodiment, the part being enlarged;
FIG. 44 is a perspective view illustrating an outer periphery portion close to a corner portion of the semiconductor chip according to the second embodiment;
FIG. 45 is a cross-sectional view of main parts illustrating the active portion of the semiconductor chip and the outer periphery portion close to the corner portion of the semiconductor chip in which the active portion corresponds to the cross section along the line A-A' illustrated in FIG. 1B and the outer periphery portion corresponds to the cross section along the line B-B' in FIG. 44; and
FIG. 46 is a plan view of main parts illustrating a part of an active region formed in an outer periphery portion of a semiconductor chip according to a modification example ofthe second embodiment, the part being enlarged.

In the embodiments described below, the invention will be described in a plurality of sections or embodiments when required as a matter of convenience. However, these sections or embodiments are not irrelevant to each other unless otherwise stated, and the one relates to the entire or a part of the other as a modification example, details, or a supplementary explanation thereof.

Also, in the embodiments described below, when referring to the number of elements (including number of pieces, values, amount, range, and the like), the number of the elements is not limited to a specific number unless otherwise stated or except the case where the number is apparently limited to a specific number in principle. The number larger or smaller than the specified number is also applicable. Further, in the embodiments described below, it goes without saying that the components (including element steps) are not always indispensable unless otherwise stated or except the case where the components are apparently indispensable in principle. Similarly, in the embodiments described below, when the shape of the components, positional relation thereof, and the like are mentioned, the substantially approximate and similar shapes and the like are included therein unless otherwise stated or except the case where it is conceivable that they are apparently excluded in principle. The same goes for the numerical value and the range described above.

In addition, when mentioning about materials etc., specified materials are main materials and thus subsidiary components, additives, additional components etc. are not excluded unless otherwise clearly mentioning that the materials are not main materials or the materials are not main ones in principle or from the situation. For example, a silicon member is not only pure silicon except the case specifying something and thus using additive impurities, binary, ternary, or other alloys (e.g., SiGe), and so forth are included. Further, in the following embodiments, when citing silicon nitride, not only Si₃N₄ but also an insulating film of nitrided silicon having a similar composition is included.

Also, in some drawings used in the embodiments, hatching is used even in a plan view so as to make the drawings easy to see. Note that components having the same function are denoted by the same reference symbols throughout the drawings for describing the embodiment, and the repetitive description thereof will be omitted. Hereinafter, embodiments of the present invention will be described in detail with reference to the accompanying drawings.

### (Problems of IGBTAssociated with Epitaxial Growth Trouble)

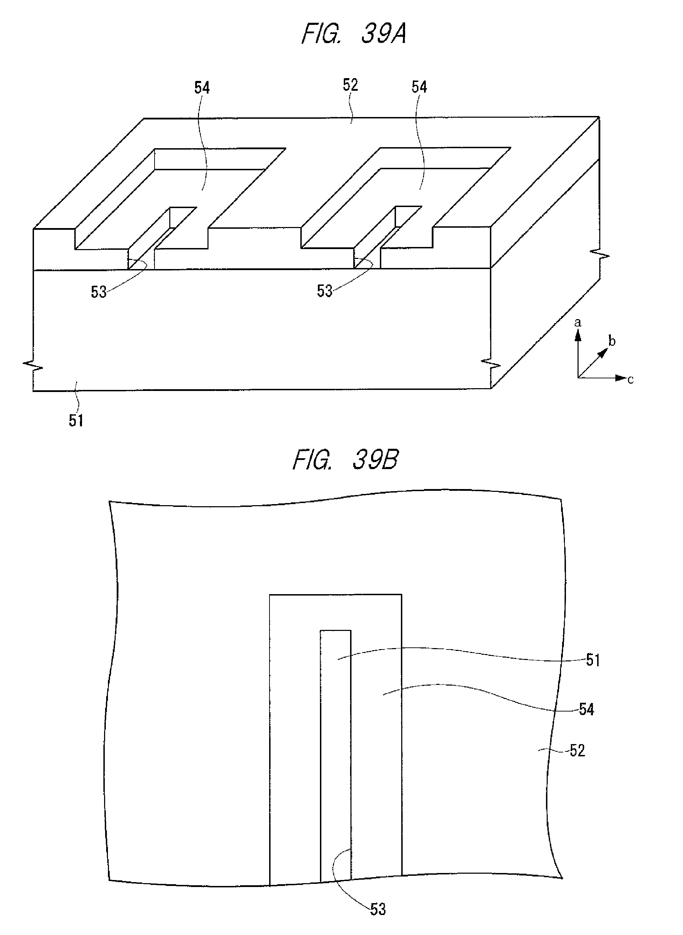

First, an epitaxial growth trouble occurring in an IGBT found by the inventors is described with reference to FIG. 39A, FIG. 39B, FIG. 40A, FIG. 40B, FIG. 41A, and FIG. 41B, because the structure of the IGBT according to present embodiment will become apparent from the description. Each of FIG. 39A, FIG. 40A, and FIG. 41A is a perspective view of main parts illustrating a part of an active portion of a semiconductor chip (one end of an active region where an element of the IGBT is formed) being enlarged, and each of FIG. 39B, FIG. 40B, and FIG. 41B is a plan view of main parts illustrating the same.

First, as illustrated in FIG. 39A and FIG. 39B, an insulating film 52 is formed on a main surface of a high-resistance semiconductor substrate (hereinafter, simply referred to as a substrate) 51 made of n⁻-type single crystal silicon. Then, in isotropic wet etching using a photoresist film patterned by photolithography as a mask, a region of the insulating film 52 serving as an active region (a region where, for example, a source region, a channel region, and an emitter region (a back gate region) are formed) is etched. In this manner, a thin film part of the insulating film 52 is formed, and the active region is defined on a main surface of the substrate 51 by a portion of the insulating film 52 not etched. The active region defined by a thick film part of the insulating film 52 is a quadrangular region having long sides in a first direction (a 'b' direction in FIG. 39A) and short sides in a second direction (a 'c' direction in FIG. 39A) orthogonal to the first direction in a planar view. Note that, while the corners of the active region are rounded in practice, the corners of the active region are illustrated with straight lines in FIG. 39A and FIG. 39B for convenience.

Next, using the photoresist film patterned by photolithography as a mask, a part of the thin film part of the insulating film 52 is etched to form an opening (a space part) 53. In this manner, a buried insulating film 54 formed of the thin film part of the insulating film 52 including the opening 53 can be formed. Here, a front surface of the substrate 51 is exposed to a bottom surface of the opening 53.

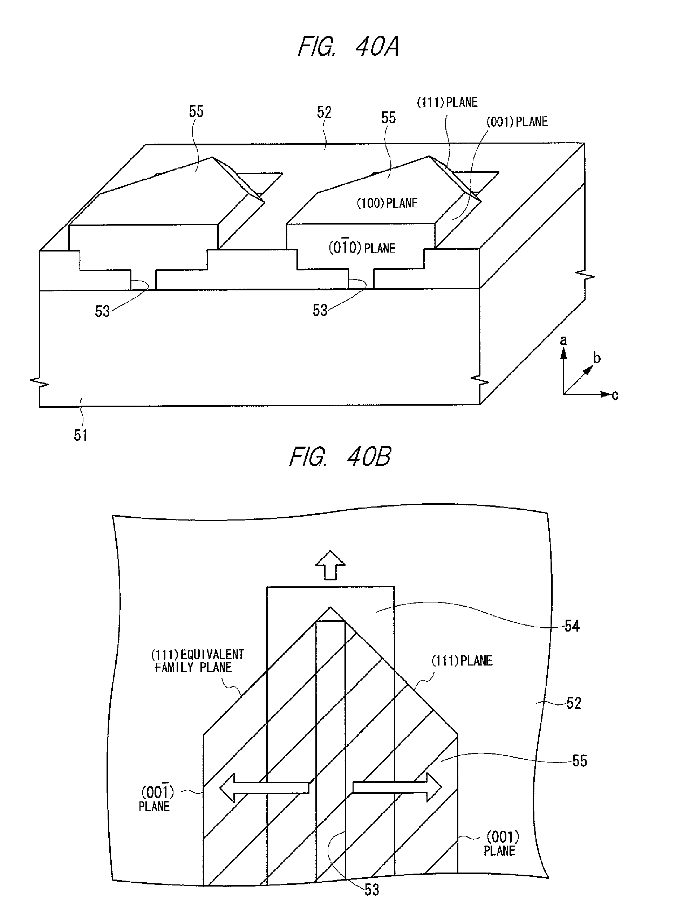

Next, as illustrated in FIG. 40A and FIG. 40B, an n⁻-type single crystal silicon film 55 having a resistivity substantially equal to a resistivity of the substrate 51 is formed by an epitaxial method so that the silicon crystal can be continued from the opening 53 of the buried insulating film 54 at a grating level.

Here, when the main surface ofthe substrate 51 made of single crystal silicon is a (100) plane, a (100) plane, a (010) plane, a (0-10) plane, a (001) plane, and a (00-1) plane grow on the single crystal silicon and also grow on upper surfaces of the thick film part and the thin film part (the buried insulating film 54) of the insulating film 52. However, once a (111) plane and a (111) equivalent family plane, which are stable planes (Facet planes), have grown, the (111) plane and the (111) equivalent family plane do not grow any more.

For this reason, on a long side side of the active region, epitaxial growth of the (001) plane and (00-1) plane continues to proceed in a second direction (a 'c' direction and a '-c' direction in FIG. 40A), and the single crystal silicon grows on the upper surfaces of the thick film part and the thin film part (the buried insulating film 54) of the insulating film52. By contrast, on a short side side of the active region, epitaxial growth of the (010) plane and the (0-10) plane in the first direction (a 'b' direction and a '-b' direction in FIG. 40A) gradually stops, and the single crystal silicon stops growing on the upper surfaces of the thick film part and the thin film part (the buried insulating film 54). In this manner, the corners of the active region defined by the thick film part of the insulating film are not filled with the single crystal silicon and a gap is formed at each corner.

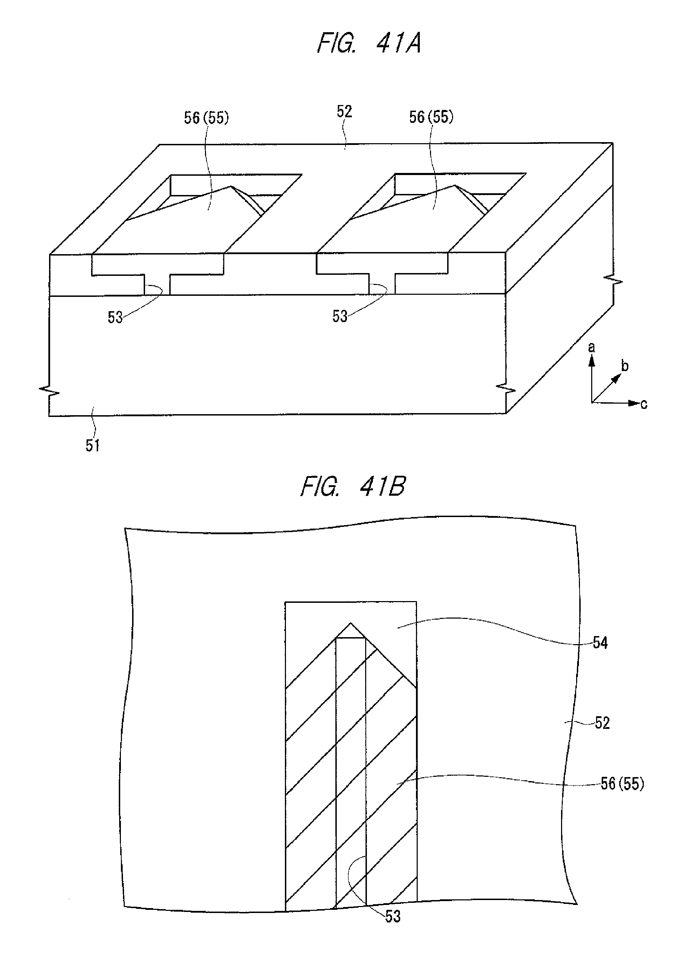

Next, as illustrated in FIG. 41A and FIG. 41B, an n-type single crystal silicon film 55 is polished by CMP using the thick film part of the insulating film 52 as a stopper (a polishing end point), thereby forming a surface semiconductor layer 56 having its thickness defined by a step height between the thick film part and the thin film part (the buried insulating film 54) of the insulating film 52.

However, the gap formed at the corners of the active region defined by the thick film part of the insulating film 52 is left as it is. For example, if a slurry solution used in a CMP process is left in this gap, a non-volatile substance (for example, silica or sulfate ions) included in the slurry solution may cause contamination. Moreover, for example, if the corners are trimmed by a polishing pad in the CMP process, a foreign substance due to removal of silicon or silicon oxide occurs. Still further, for example, when a photoresist film is patterned by photolithography in a subsequent process, irregular light reflection due to this gap may occur, thereby making it impossible to form a desired resist pattern. For this reason, in the active region, it is required not to form a gap between the thick film part of the insulating film 52 and the surface semiconductor layer 56.

### (First Embodiment)

### <<Semiconductor Device>>

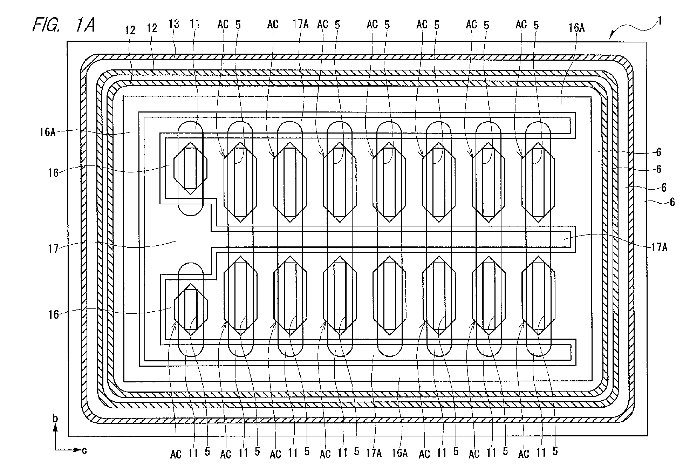

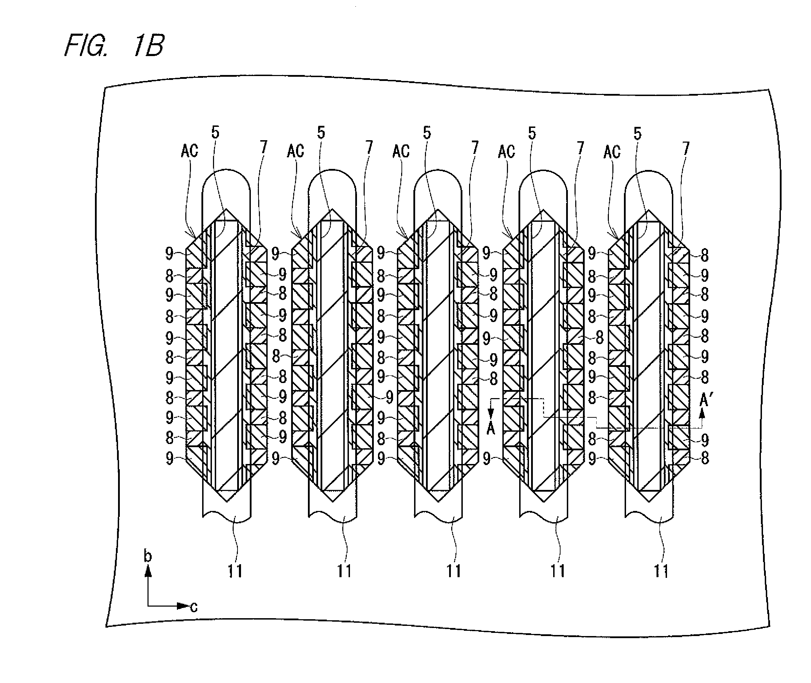

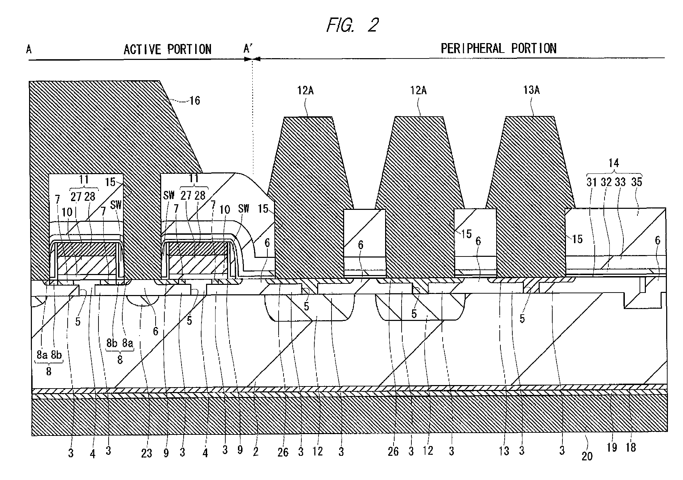

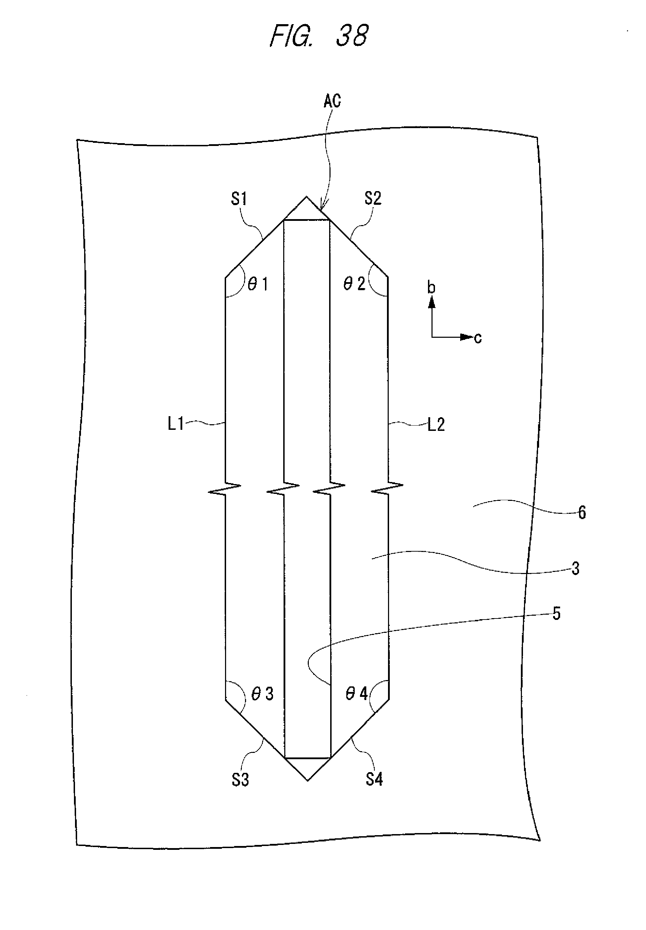

A semiconductor device including an IGBT according to a first embodiment is described with reference to FIG. 1A, FIG. 1B, FIG. 2, and FIG. 38. FIG. 1A and FIG. 1B are plan views of main parts of a semiconductor chip in which an IGBT is formed. In an active portion illustrated in FIG. 1A, a region where an element of the IGBT is formed is partially enlarged. FIG. 1B illustrates only the region where an element of the IGBT is formed being further enlarged. FIG. 2 is a plan view of main parts illustrating the active portion and a peripheral portion of the semiconductor chip (a plan view of main parts in which the active portion corresponds to a cross section along an A-A' line illustrated in FIG. 1B). FIG. 38 is a plan view of main parts illustrating the active portion of the semiconductor chip (the active region where an element of the IGBT is formed) being partially enlarged.

On the active portion of a semiconductor chip 1, an element of the IGBT is formed. The element of the IGBT has a structure in which, for example, a plurality of surface semiconductor layers 4 made of n⁻-type single crystal silicon are formed on a main surface (a front surface) of a base layer 2 made of n⁻-type single crystal silicon via a buried insulating film 3 and the base layer 2 and the surface semiconductor layers 4 are connected together through openings (space parts) 5 formed in the buried insulating film 3. Also, by a plurality of insulating films 6 thicker than the buried insulating film 3, a plurality of active regions AC are defined on the main surface of the base layer 2, and the plurality of active regions AC each have the surface semiconductor layer 4 formed thereon.

While the thickness of the base layer 2 is, for example, 70 µm to 100 m, this is determined according to the withstand voltage of the IGBT. If the withstand voltage is 600 V, the thickness can be exemplarily set at 60 µm to 100 µm. If the withstand voltage is 1200 V, the thickness can be exemplarily set at 120 µm to 150 µm. Also, the thickness of the surface semiconductor layer 4 is set in a range smaller than or equal to 100 nm, more preferably in a range of 20 nm to 40 nm, in order to reduce a stationary loss, a turnoff time, and a tumoffloss of the IGBT.

Each of the active regions AC where an element of the IGBT is formed is a region having long sides in a first direction (a 'b' direction in FIG. 1A and FIG. 1B) and short sides each being shorter than the long side in a second direction (a 'c' direction in FIG. 1A and FIG. 1B) orthogonal to the first direction in a planar view. Also, each of the active regions AC is in a pattern having a certain width in the second direction in the planar view and extending in a band shape in the first direction, and the plurality of active regions AC are arranged in a stripe form. Note that FIG. 1A only illustrates eight active regions AC for every line, that is, sixteen in total, in an enlarged manner while, for example, about seven hundred active regions are formed so as to be spaced apart from each other along the second direction in practice.

Furthermore, the shape of each ofboth ends of the active region AC in the first direction in the planar view is a triangle having a projecting center. According to the shape of the single crystal silicon forming the surface semiconductor layer 4 under epitaxial growth, each of the both ends of the active region AC in the first direction is configured of two short sides, and these two short sides each have an angle with respect to the first direction.

That is, as illustrated in FIG. 38, the active region AC has a first long side L1 extending in a first direction (a 'b' direction in FIG. 38) and a second long side L2 extending in the first direction with a certain space from the first long side L1 in a second direction (a 'c' direction in FIG. 38) in a planar view. Furthermore, one end of the first long side L1 has a first short side S1 forming a first angle θ1 with the first long side L1 and one end of the second long side L2 has a second short side S2 forming a second angle θ2 with the second long side L2. The other end of the first long side L1 has a third short side S3 forming a third angle θ3 with the first long side L1 and the other end of the second long side L2 has a fourth short side S4 forming a fourth angle θ4 with the second long side L2. The first angle θ1, the second angle θ2, the third angle θ3, and the fourth angle θ4 are in a range larger than 90 degrees and smaller than 180 degrees. Without formation of a gap between the insulating film 6 defining the active region AC and the surface semiconductor layer 4, the semiconductor layer 4 is formed on this active regionAC.

For example, when a crystal plane on the main surface of the base layer 2 is a (100) plane of single crystal silicon, the crystal plane on an upper surface of the surface semiconductor layer 4 is a (100) plane. Also, a crystal plane of the surface semiconductor layer 4 along the first long side L1 is a (00-1) plane, and a crystal plane of the surface semiconductor layer 4 along the second long side L2 is a (001) plane. Also, as described above (refer to FIG. 39A to FIG. 41B), at both ends of the active region AC in the first direction, epitaxial growth of single crystal silicon configuring the surface semiconductor layer 4 stops when a (111) plane is formed. Thus, a second inclined surface having a (111) plane, a first inclined surface having a (111) equivalent family plane, a third inclined surface, and a fourth inclined surface are formed.

In this case, the corners of the active region AC are set to have angles (the first angle θ1, the second angle θ2, the third angle θ3, and the fourth angle θ4) each being 135 degrees. With the angle of each corner of the active region AC being set at 135 degrees, epitaxial growth of the (111) plane and the (111) equivalent family plane of the surface semiconductor layer 4 along the first short side S1, the second short side S2, the third short side S3, and the fourth short side S4 of the active region AC stops. Therefore, the surface semiconductor layer 4 is formed on the active region AC without forming a gap on the active region AC.

The four corners of the opening 5 are formed so as to be in contact with the first short side S1, the second short side S2, the third short side S3, and the fourth short side S4 of the active region AC in a planar view.

On the surface semiconductor layer 4 on the buried insulating film 3, a p-type channel layer 7, an n-type source layer 8 including an n⁺-type source layer 8a and an n⁻-type source layer 8b, and a p⁺-type emitter layer (a p-type back gate layer) 9 are formed. An impurity concentration in the n⁺-type source layer 8a is higher than an impurity concentration in the n⁻-type source layer 8b, and the n⁻-type source layer 8b is formed on a p-type channel layer 7 side (between the p-type channel layer 7 and the n⁺-type source layer 8a). Also, an impurity concentration in the p⁺-type emitter layer 9 is higher than an impurity concentration in the p-type channel layer 7.

On each of the surface semiconductor layers 4, a gate electrode 11 is patterned via a gate electrode 10. The gate electrode 11 is a pattern extending in a band shape in the first direction in a planar view. The plurality of gate electrodes 11 are separated away from each other and are arranged in a stripe form. The gate electrode 11 is configured of, for example, a stacked film having a polycrystalline silicon film 27 and a tungsten silicide layer 28 sequentially deposited from below.

The n-type source layer 8 and the p⁺-type emitter layer 9 described above cannot be formed in the same section. For this reason, the n-type source layer 8 and the p⁺-type emitter layer 9 are alternately arranged in one band-shaped region extending between the gate electrode 11 and the insulating film 6 in a planar view. Also, by setting the plane area of the n-type source layer 8 to be smaller than the plane area of the p⁺-type emitter layer 9, destruction tolerance is increased. The p-type channel layer 7 is formed between the gate electrode 11 and the buried insulating film 3. Also, since the p-type channel layer 7 is connected to a p⁺-type emitter layer 9 to fix the potential, degradation in characteristics due to formation of a parasitic MOS (Metal Oxide Semiconductor) can be prevented.

The gate electrode 11 has side surfaces having side walls SW. When impurities are ion-implanted to the surface semiconductor layer 4 below the side surfaces of the gate electrode 11 at a high concentration using the gate electrode 11 as a mask, it is concerned that a crystal defect may occur in the surface semiconductor layer 4 below the side surfaces of the gate electrode 11 due to a subsequent heating process. Thus, by forming the side walls SW on the side surfaces of the gate electrode 11 and ion-implanting impurities at a high concentration into the surface semiconductor layer 4 below the ends of the side walls SW using the side walls SW as masks, a crystal defect is prevented from occurring in the surface semiconductor layer 4 below the side surfaces of the gate electrode 11. That is, the n⁻-type source layer 8b at a low concentration is formed on a portion of the surface semiconductor layer 4 near a portion below the side surfaces of the gate electrode 11, and the n⁺-type source layer 8a at a high concentration is formed on a portion of the surface semiconductor layer 4 near a portion below the ends of the side walls SW.

In the base layer 2 below the plurality of the insulating films 6 in the active portion, p-type wells 23 are provided. While the junction withstand voltage is kept by depletion layers expanding from a pn junction part between the p-type channel layer 7 and the base layer 2 to the base layer 2, by auxiliary providing the p-type well 23, the junction withstand voltage can be further increased.

In the peripheral portion (a part inside each side of the semiconductor chip 1) of the semiconductor chip 1, a plurality of p type field limiting rings 12 are formed so as to surround the active portion in a planar view and, furthermore, an n-type guard ring (a channel stopper) 13 is formed so as to surround the plurality of the p-type field limiting rings 12.

The p-type field limiting rings 12 are formed by introducing impurities exhibiting p-type characteristics into the base layer 2. Also, the p-type field limiting rings 12 are each connected to a p⁺-type semiconductor layer 26 to which impurities exhibiting p-type characteristics are introduced (formed similarly to the surface semiconductor layer 4 and having an impurity concentration substantially equal to the impurity concentration in the p⁺-type emitter layer 9) through openings 5 formed in the buried insulating film 3. By the field limiting electrodes 12A, the voltage is fixed. While FIG. 1A and FIG. 2 illustrate an example in which two p-type field limiting rings 12 are formed, more rings may be formed. According to the formation of the plurality of p-type field limiting rings 12 as described above, the electric field is shared by the plurality of p-type field limiting rings 12, and therefore a high withstand voltage can be achieved in the IGBT according to the first embodiment.

The n-type guard ring 13 formed so as to surround the plurality of p-type field limiting rings 12 has a function of protecting the element of the IGBT in the semiconductor chip 1 after the semiconductor chip 1 is singulated from the semiconductor wafer. The n-type guard ring 13 is formed in a manner similar to that of the surface semiconductor layer 4, and has a structure in which impurities exhibiting n-type characteristics are introduced. By a guard ring electrode 13A, the voltage is fixed. The n-type guard ring 13 has an impurity concentration substantially equal to the impurity concentration in the n⁺-type source layer 8a.

Furthermore, the element of the IGBT, the p-type field limiting ring 12, and an interlayer insulating film 14 covering the n-type guard ring 13 are formed in the active portion and the peripheral portion of the semiconductor chip 1. The interlayer insulating film 14 is configured of a stacked film formed of, for example, a silicon oxide film 31, a silicon nitride film 32, a silicon oxide film 33, and a stacked insulating film 35 of a PSG (Phospho Silicate Glass) film and a SOG (Spin on Glass) film deposited in this order from the bottom. In this interlayer insulating film 14, the n-type source layer 8, the p⁺-type emitter layer 9, the gate electrode 11, the p⁺-type semiconductor layer 26, and openings 15 reaching the n-type guard ring 13 are formed.

In the situation in which the openings 15 are formed, a source pad (source electrode) 16 to be connected to the n-type source layer 8 and the p⁺-type emitter layer 9, a gate pad 17 to be connected to the gate electrode 11, a field limiting ring electrode 12A to be connected to the p⁺-type semiconductor layer 26, and a guard ring electrode 13A to be connected to the n-type guard ring 13 are formed so as to be separated apart from each other. The source pad 16 and others are formed of, for example, A1 (aluminum). Around the perimeter of the active portion (a region between the region where an element of the IGBT is formed and the peripheral portion), a source routing electrode 16A is formed in succession to the source pad 16. The source routing electrode 16A is connected to a p⁺-type emitter layer (omitted in the drawings) formed around the perimeter of the active portion through an opening (omitted in the drawings) formed in the interlayer insulating film 14 below the source routing electrode 16A. Also, gate fingers 17A are formed on the center part of the active portion and at both ends of the active portion in the first direction. The gate fingers 17A are each connected to the gate electrode 11 through an opening formed in the interlayer insulating film 14 below the gate fingers 17A to extend in succession to the gate pad 17 in the second direction.

Furthermore, a polyimide film (omitted in the drawings) covering the source pad 16 and others is formed. In the polyimide film, openings from which the surface of a part of each source pad 16 and the surface of a part of the gate pad 17 are exposed are formed. These openings serve as bonding pads for connecting bonding wires for electrically connecting the semiconductor chip 1 to the outside. Note that an opening for exposing the surface of a part of the guard ring electrode 13A may be formed as required in the polyimide film.

On a rear surface of the base layer 2, an n-type buffer layer 18, a p-type collector layer 19, and a collector electrode 20 are formed in this order in which the closest to the base layer 2 comes first. To increase a switching speed and reduce switching loss, it is desired to decrease the amount of hole injection from the rear surface, and it is required to reduce the concentration of impurities exhibiting the p-type characteristics introduced to the p-type collector layer 19. However, due to the low impurity concentration, the resistivity of the p-type collector layer 19 is increased For this reason, the p-type collector layer 19 is required to be formed thinly in order to reduce series resistance components of the p-type collector layer 19, and its thickness is preferably, for example, smaller than or equal to 5 µm. Furthermore, in consideration of a small diffusion coefficient of B (boron), which is an impurity exhibiting the p-type characteristics and introduced to the p-type collector layer 19, the thickness of the p-type collector layer 19 is preferably, for example, smaller than or equal to 1 µm. The collector electrode 20 is formed of a metal film obtained by stacking an Al (aluminum) film, a Ti (titanium) film, a Ni (nickel) film, and an Au (gold) film in this order in which the closest to the p-type collector layer 19 comes first. Also, the collector electrode 20 is formed of a metal film obtained by stacking a Ni (nickel) film, a Ti (titanium) film, a Ni (nickel) film, and an Au (gold) film, or a metal film obtained by laminating a Ti (titanium) film, a Ni (nickel) film, and an Au (gold) film, each in the order in which the closest to the p-type collector layer 19 comes first.

### «Semiconductor Device Manufacturing Method»

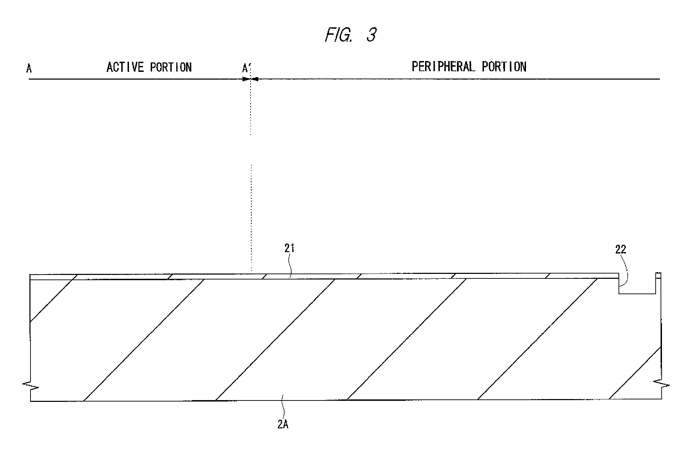

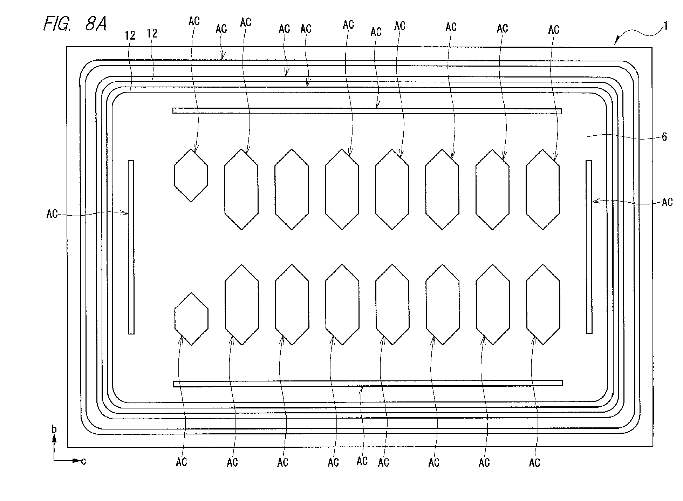

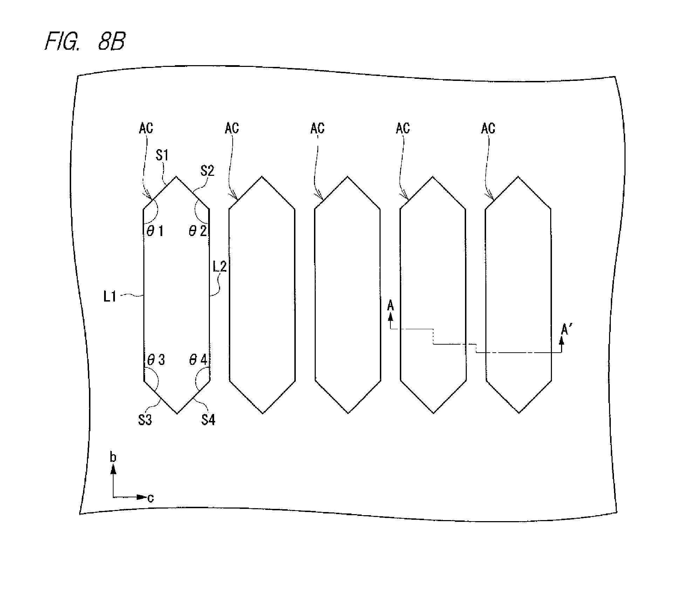

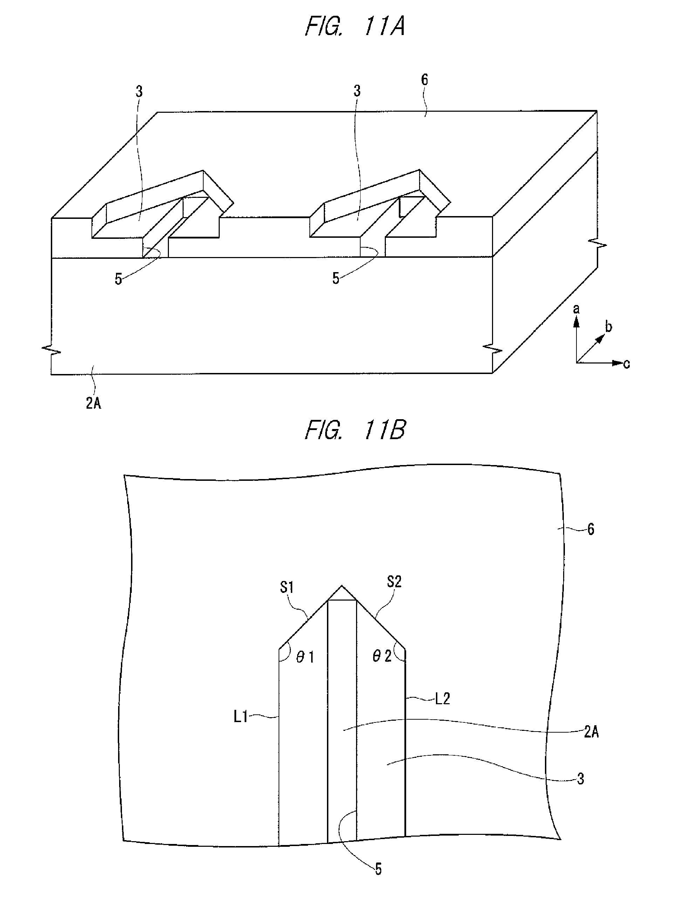

A method of manufacturing the semiconductor device including the IGBT according to the first embodiment will be described in a process sequence with reference to FIG. 3 to FIG. 35. FIG. 3 to FIG. 7, FIG. 9, FIG. 12, FIG. 15, FIG. 17, FIG. 18, FIG. 20, FIG. 22 to FIG. 24, FIG. 26 to FIG. 29, FIG. 31 to FIG. 33, and FIG. 35 are cross-sectional views of main parts each illustrating the active portion and the peripheral portion of the semiconductor chip (sectional views of main parts in which the active portion corresponds to the cross section along the A-A' line illustrated in FIG. 1B). FIG. 8A, FIG. 10A, FIG. 13A, FIG. 19A, FIG. 21A, FIG. 25A, FIG. 30A, and FIG. 34A are plan views of main parts each illustrating the semiconductor chip (plan views of main parts in which the active region of the semiconductor chip is partially enlarged). FIG. 8B, FIG. 10B, FIG. 13B, FIG. 19B, FIG. 21B, FIG. 25B, FIG. 30B, and FIG. 34B are plan views of main parts illustrating only the region where an element of the IGBT is formed being further enlarged. FIG. 11A, FIG. 14A, and FIG. 16A are perspective views of main parts illustrating a part of the active portion of the semiconductor chip (one end of the active region where an element of the IGBT is formed) being partially enlarged, and FIG. 11B, FIG. 14B, and FIG. 16B are plan views of the main parts illustrating the part of the active portion of the semiconductor chip (one end of the active region where an element of the IGBT is formed) being partially enlarged.

First, as illustrated in FIG. 3, a semiconductor substrate (hereinafter, simply referred to as a substrate) 2A having a high resistance made of n⁻-type single crystal silicon is prepared. A desirable type of the crystal forming the substrate 2A is a FZ (Float Zoning; Floating Zone) crystal manufactured by a floating zone method, a CZ (Czochralski) crystal manufactured by the Czochralski process (a pulling method), or a MCZ (Magnetic Field Applied Czochralski) crystal.

Next, a surface oxide film 21 is formed on a main surface (a front surface) of the substrate 2Aby performing a thermal oxidation process on the substrate 2A. Subsequently, using a photoresist film patterned by photolithography as a mask, the surface oxide film 21 and the substrate 2A in a predetermined region of the peripheral portion are sequentially etched to form a trench 22 for use as an alignment mark for alignment on the peripheral portion of the substrate 2A.

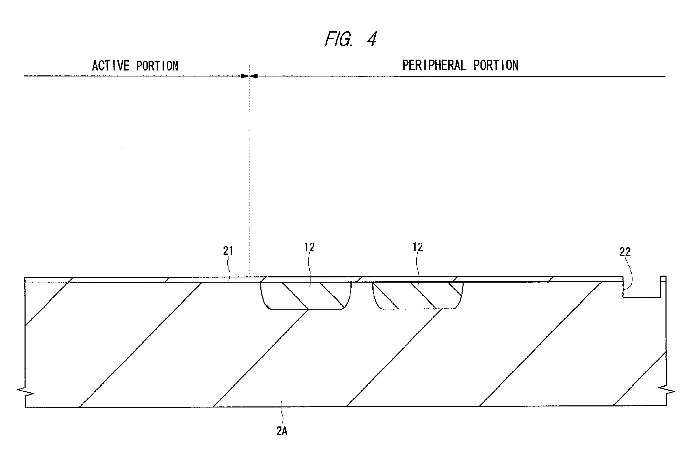

Next, as illustrated in FIG. 4, using a photoresist film patterned by photolithography as a mask, impurities exhibiting the p-type (for example, B (boron)) characteristics are introduced to the peripheral portion on the main surface of the substrate 2A by ion implantation, thereby forming a plurality of p-type field limiting rings 12.

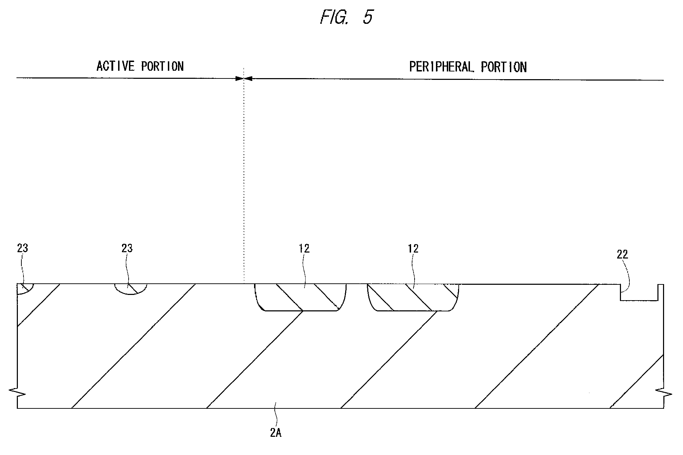

Next, as illustrated in FIG. 5, using a photoresist film patterned by photolithography as a mask, impurities exhibiting the p-type (for example, B (boron)) characteristics are introduced to the active portion on the main surface of the substrate 2Aby ion implantation, thereby forming a plurality of p-type wells 23.

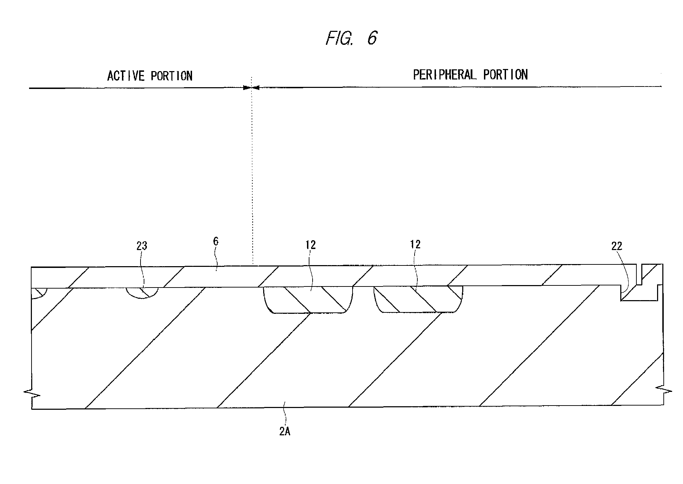

Next, as illustrated in FIG. 6, by performing a thermal oxidation process on the substrate 2A, a surface oxide film (omitted in the drawing) is formed on the main surface of the substrate 2A. Subsequently, an oxide film (omitted in the drawing) is deposited on this surface oxide film by CVD (Chemical Vapor Deposition) to form the insulating film 6 formed of the surface oxide film and the oxide film described above. The insulating film 6 has a thickness of, for example, 600 nm. Here, the inside of the trench 22 provided on the peripheral portion is not entirely filled with the insulating film 6.

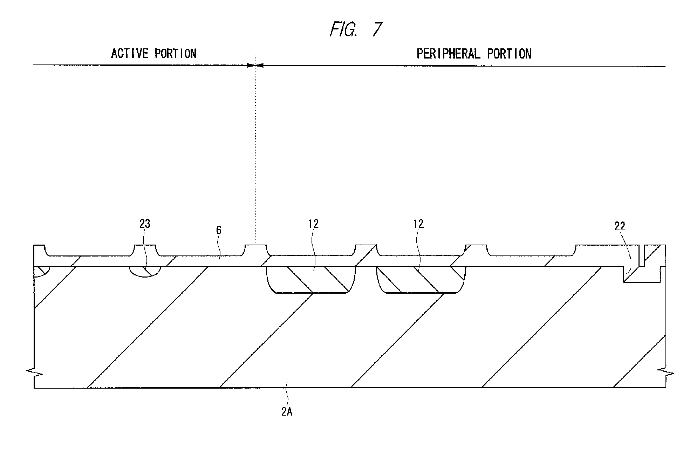

Next, as illustrated in FIG. 7, FIG. 8A, and FIG. 8B, by isotropic wet etching using a photoresist film patterned by photolithography as a mask, portions of the insulating film 6 in regions serving as active regions (for example, regions where a source layer, a channel layer, and an emitter layer (a back gate layer) are formed) are etched by, for example, 30 nm to 110 nm. In this manner, active regions AC are defined on the main surface of the substrate 2A by portions of the insulating film 6 not etched. In the first embodiment, in a region where the element of the IGBT in the active portion is formed, a region where a thick film part of the insulating film 6 is formed and a region where a thin film part of the insulating film 6 is formed are alternately placed in a stripe form. Furthermore, a thin film part of the insulating film 6 is formed also in a region where a p⁺-type emitter layer (a p⁺-type emitter layer denoted by a reference numeral 9 further below) around the perimeter of the active portion is formed, a region on the p⁺-type field limiting ring 12 in the peripheral portion and a region where an n⁺-type guard ring (an n⁺-type guard ring denoted by a reference numeral 13 further below) is formed.

The active region AC where the element of the IGBT is formed is a region having long sides in a first direction (a 'b' direction in FIG. 8) and short sides shorter than the long sides in a second direction (a 'c' direction in FIG. 8) orthogonal to the first direction in a planar view. Furthermore, both ends of the active region AC in the first direction are each configured of two short sides, and these two short sides each have an angle in the first direction. That is, the active region AC has a first long side L1 extending in a first direction and a second long side L2 extending in the first direction with a predetermined space provided in a second direction with respect to the first long side L1 in a planar view. Furthermore, one end of the first long side L1 has a first short side S1 forming a first angle θ1 with the first long side L1 and one end of the second long side L2 has a second short side S2 forming a second angle θ2 with the second long side L2. The other end of the first long side L1 has a third short side S3 forming a third angle θ3 with the first long side L1 and the other end of the second long side L2 has a fourth short side S4 forming a fourth angle θ4 with the second long side L2. The first angle θ1, the second angle θ2, the third angle θ3, and the fourth angle θ4 are in a range larger than 90 degrees and smaller than 180 degrees.

Also, in the first embodiment, isotropic wet etching is used as etching of the insulating film described above. The reason for this is that since isotropic wet etching can etch the insulating film 6 having better controllability than dry etching, variations in thickness of the thin film part of the insulating film 6 can be suppressed. As will be described further below, while the thin film part of the insulating film 6 forms the buried insulating film 3, by the formation of the buried insulating film 3 having a uniform thickness, fluctuations in characteristics of the IGBT due to variations in capability of Hall current element can be suppressed. Note that while the corners of the active region AC are rounded in practice, the corners of the active region AC are illustrated with straight lines for convenience.

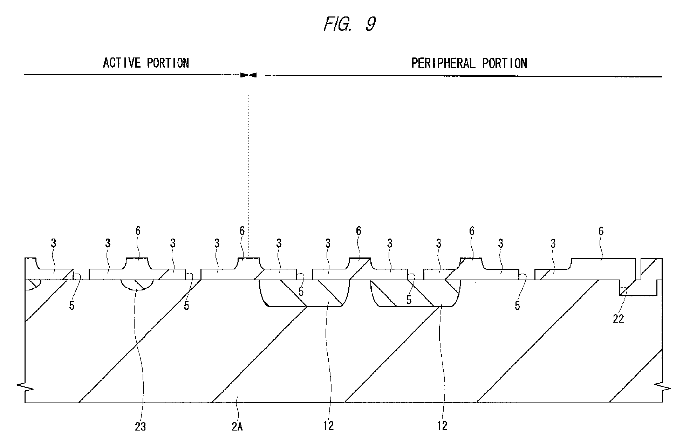

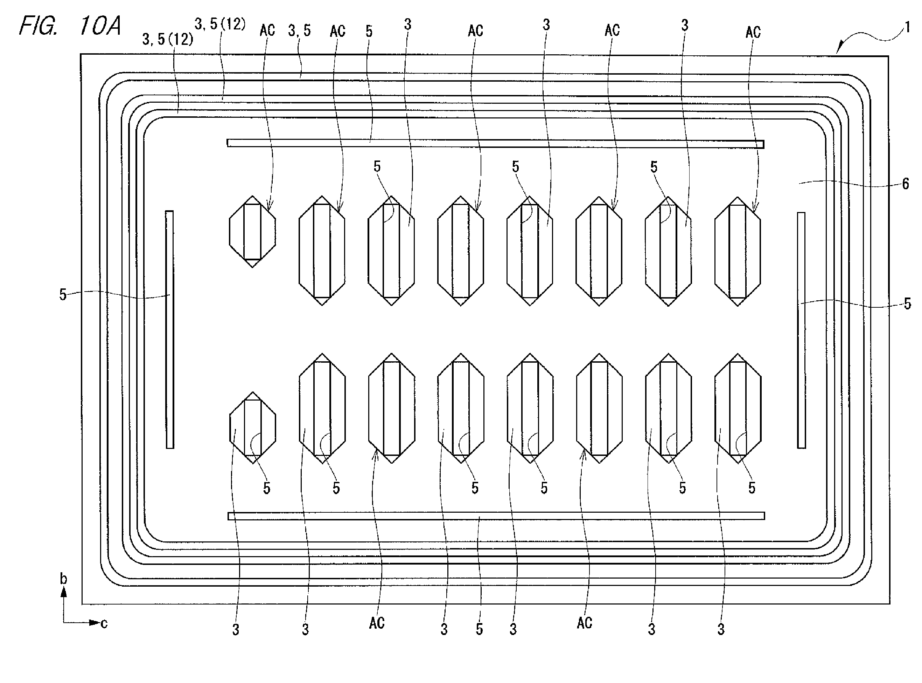

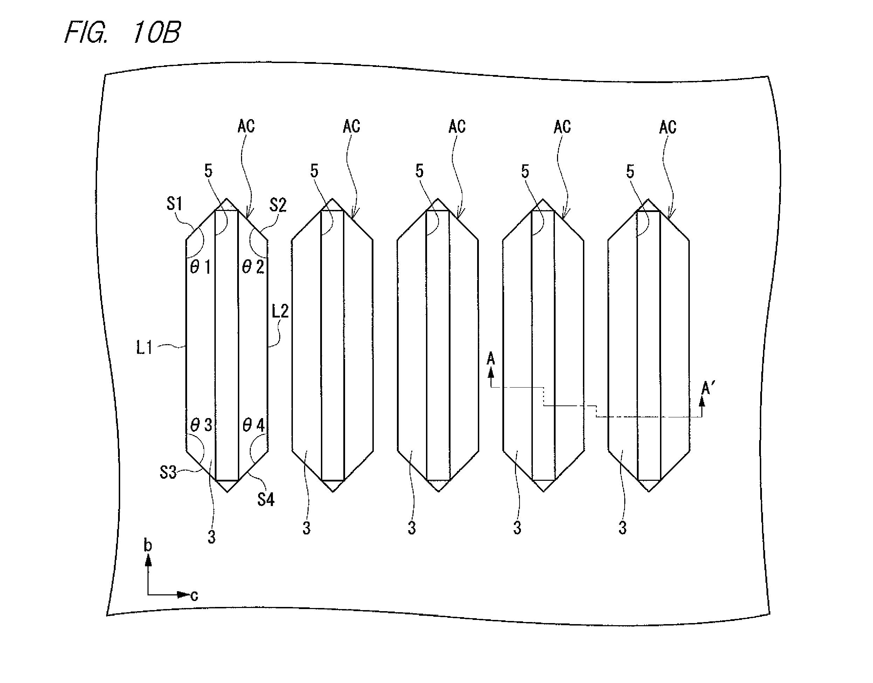

Next, as illustrated in FIG. 9, FIG. 10A, FIG. 10B, and FIG. 11, using a photoresist film patterned by photolithography as a mask, a part of the thin film part of the insulating film 6 is etched to form an opening (a space part) 5. In this manner, the buried insulating film 3 formed of the thin film part of the insulating film 6 including the opening 5 can be formed. Here, the surface of the substrate 2A is exposed from a bottom surface of the opening 5. Furthermore, four corners of the opening 5 in the active region AC where an element of the IGBT is formed are formed so as to be in contact with the first short side S1, the second short side S2, the third short side S3, and the fourth short side S4, respectively, on both sides of the active region AC in the first direction. Note that, while the opening 5 is formed also in the buried insulating film 3 in a region in the peripheral portion where the p-type field limiting ring 12 and an n-type guard ring (an n-type guard ring denoted by a reference numeral 13 further below) are formed, they are omitted in FIG. 10.

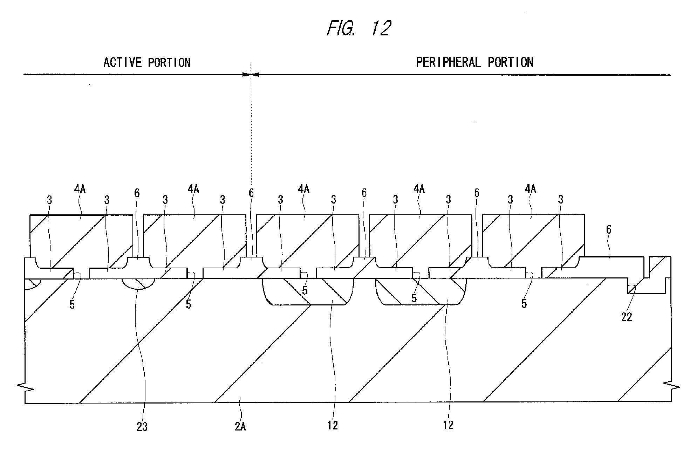

Next, as illustrated in FIG. 12, FIG. 13A, FIG. 13B, and FIG. 14, the n⁻-type single crystal silicon film 4A having a resistivity substantially equal to the resistivity of the substrate 2A is formed by an epitaxial method so that the silicon crystal can be continued from the opening 5 of the buried insulating film 3 at a grating level.

For example, when the main surface of the substrate made of single crystal silicon is a (100) plane, a (100) plane, a (010) plane, a (0-10) plane, a (001) plane, and a (00-1) plane of the n⁻-type single crystal silicon film 4A grow and also grow on upper surfaces of the buried insulating film 3 and the insulating film 6. However, once a (111) plane and a (111) equivalent family plane, which are stable surfaces (Facet surfaces), have grown, the (111) plane and the (111) equivalent family plane do not grow any more.

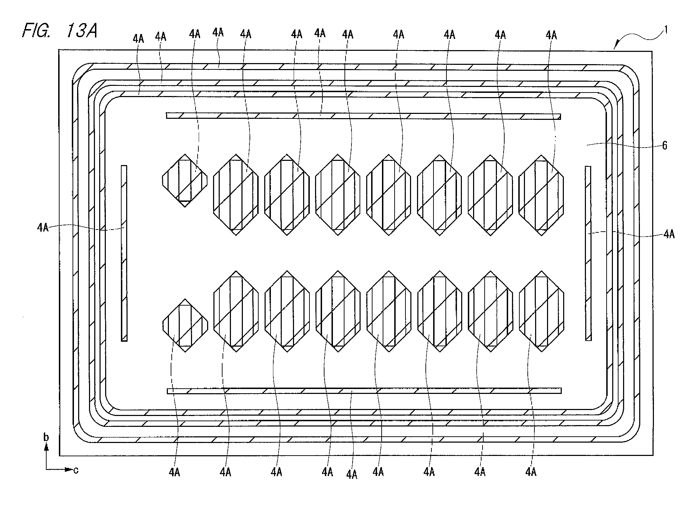

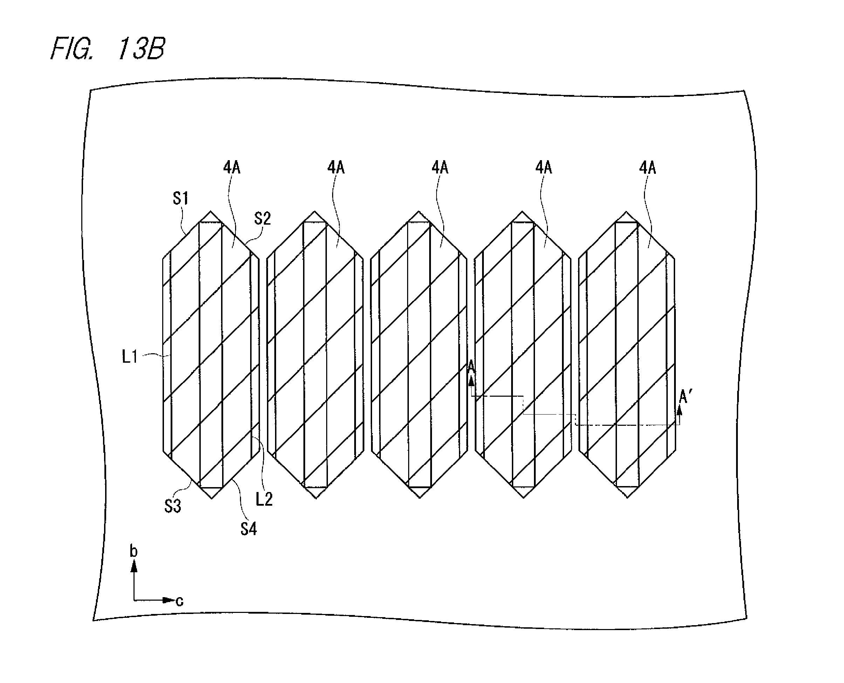

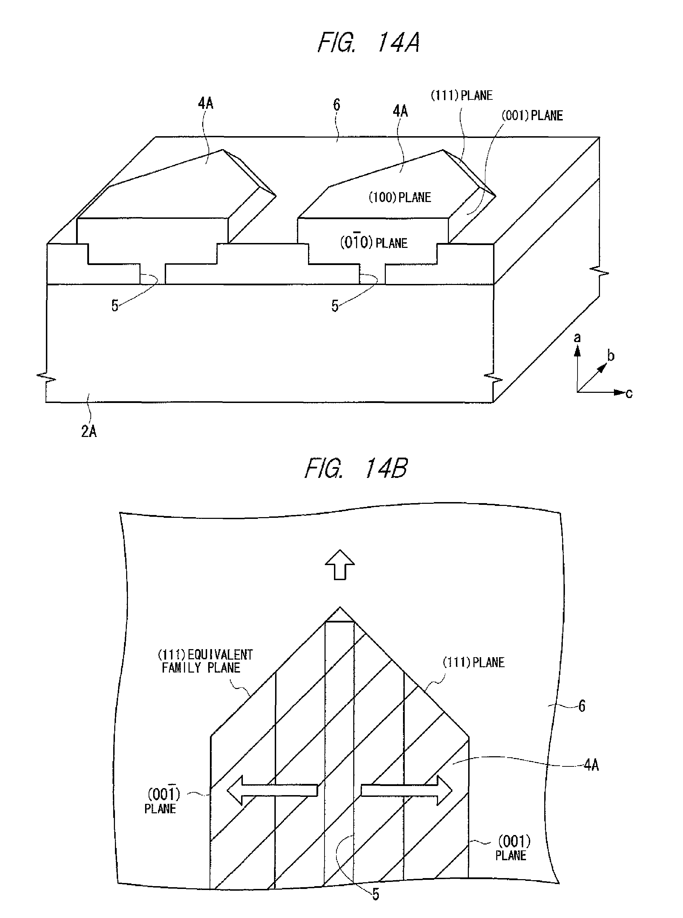

For this reason, on the long side (the first long side L1 and the second long side L2) sides of the active region AC where an element of the IGBT is formed, epitaxial growth of the (001) plane and (00-1) plane continues to proceed in a second direction (a 'c' direction and a '-c' direction in FIG. 13 and FIG. 14), and the n⁻-typc single crystal silicon film 4A is formed on the upper surfaces of the buried insulating film 3 and the insulating film 6. By contrast, on the short side sides of the active region AC where an element of the IGBT is formed, epitaxial growth of the (010) plane and the (0-10) plane in the first direction (a 'b' direction and a '-b' direction in FIG. 13 and FIG. 14) gradually stops. Then, a second inclined surface having a (111) plane, a first inclined surface having a (111) equivalent family plane, a third inclined surface, and a fourth inclined surface are formed to form an angle of 135 degrees with respect to the first direction, thereby forming the n⁻-type single crystal silicon film 4A.

However, if the first short side S1, the second short side S2, the third short side S3, and the fourth short side S4 are formed so as to match the shape of the n⁻-type single crystal silicon film 4A which epitaxially grows, the active region AC can be filled with the n⁻-type single crystal silicon film 4A without forming a gap between the insulating film 6 defining the active regionAC and the n⁻-type single crystal silicon film 4A.

When the main surface of the substrate 2A made of single crystal silicon is a (100) plane, if the (111) plane and the (111) equivalent family plane grow at both ends of the active region AC in the first direction, epitaxial growth stops with an angle of 135 degrees with respect to the first long side L1 and the second long side L2 along the first direction. To address this, a first angle θ1, a second angle θ2, a third angle θ3, and a fourth angle θ4 of the active region AC are set at 135 degrees. In this manner, the first inclined surface of the n⁻-type single crystal silicon film 4A is formed along the first short side S1 of the active region AC, and the second inclined surface of the n⁻-type single crystal silicon film 4A is formed along the second short side S2 of the active region AC. Furthermore, the third inclined surface of the n⁻-type single crystal silicon film 4A is formed along the third short side S3 of the active region AC, and the fourth inclined surface of the n⁻-type single crystal silicon film 4A is formed along the fourth short side S4 of the active region AC. Therefore, the n⁻-type single crystal silicon film 4A can be formed without forming a gap in the active regionAC.

Also, when each of the four corners of the opening 5 in the active region AC where the element of the IGBT is formed is away from a relevant one of the first short side S1, the second short side S2, the third short side S3, and the fourth short side S4 in the active region AC, a gap may be formed between each corner and a relevant one of the first short side S1, the second short side S2, the third short side S3, and the fourth short side S4 without filling the n⁻-type single crystal silicon film 4A. This is because epitaxial growth stops at each corner. However, in the first embodiment, each of the four corners of the opening 5 in the active region AC where an element of the IGBT is formed is formed so as to be in contact with a relevant one of the first short side S1, the second short side S2, the third short side S3, and the fourth short side S4. Therefore, the gap problem described above does not occur.

However, due to alignment variations, process variations, and others in each manufacturing process, each of the four corners of the opening 5 in the active region AC where an element of the IGBT is formed may be away from a relevant one of the first short side S 1, the second short side S2, the third short side S3, and the fourth short side S4. Also, for example, depending on a plane direction in which epitaxial growth of the single crystal silicon proceeds, a gap may be formed between each corner and a relevant one of the first short side S1, the second short side S2, the third short side S3, and the fourth short side S4. However, this gap is subtle, and the problem described above with reference to FIG. 39 to FIG. 41 is mitigated.

Also, here, epitaxial film formation conditions having selectivity are adopted so that polycrystalline silicon is not deposited on the front surface of the buried insulating film 3. That is, for example, after the substrate 2A is introduced to an epitaxial furnace, means of using a carrier gas having H₂ (hydrogen) gas as a main component to supply a mixed gas of SiHCl₃ (trichlorosilane) and HCl (hydrochloric acid) to the furnace or means of using a carrier gas containing H₂ (hydrogen) gas as a main component to supply a mixed gas of SiH₂Cl₂ (dichlorosilane) and HCl (hydrochloric acid) can be adopted. Of the gas to be introduced to the epitaxial furnace, the HCl gas has a light etching capability with respect to silicon crystal, and therefore can inhibit polycrystalline silicon from being deposited on the buried insulating film 3. However, since the etching power of the HCl gas is not strong enough to inhibit epitaxial film formation of crystal silicon continued to be formed from the crystal (the substrate 2A) below the opening 5, selective epitaxial film formation can be made from the opening 5.

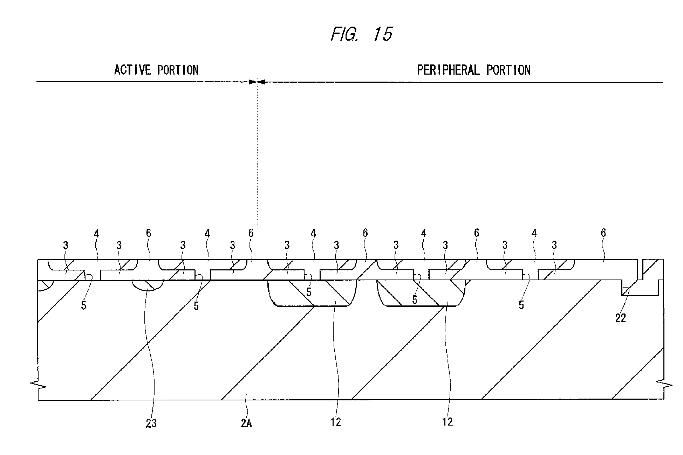

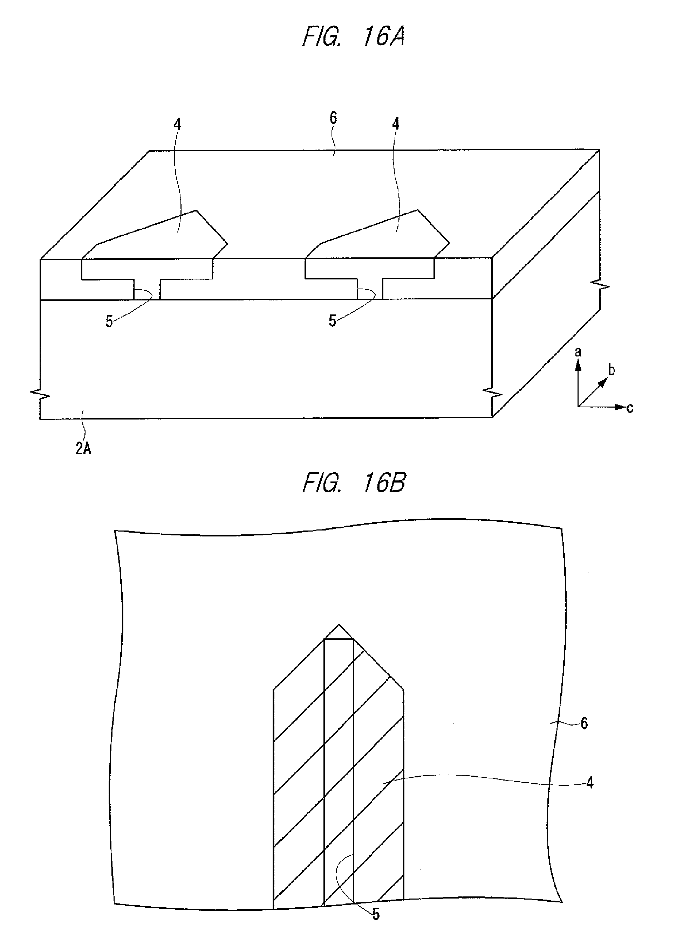

Next, as illustrated in FIG. 15 and FIG. 16, by performing CMP using the thick fihn part of the insulating film 6 as a stopper (a polishing end point), the n⁻-type single crystal silicon film 4A is polished, thereby forming the surface semiconductor layer 4 with its thickness defined by a step height between the thick film part and the thin film part (the buried insulating film 3) of the insulating film 6. Since the active region AC is filled with the n⁻-type single crystal silicon film 4A where an element of the IGBT is formed without forming a gap, the active region AC can be filled with the surface semiconductor layer 4 without a gap. In this manner, for example, it is possible to prevent contamination due to the residue of a non-volatile substance (for example, silica, sulfate ions, or others) contained in slurry solution used in the CMP process. It is also possible to prevent the occurrence of a foreign substance due to separation of silicon or silicon oxide occurring at the corners of the active region AC reduced by a polishing pad in the CMP process. Furthermore, for example, when a photoresist film is patterned by photolithography in a subsequent process, it is possible to prevent the occurrence of irregular reflection of light due to a gap occurring in the active region AC.

It has been described that the thickness of the surface semiconductor layer 4 is, for example, 20 nm to 100 nm in the first embodiment. However, the front surface of the surface semiconductor layer 4 is sacrificed by a predetermined thickness in a process of forming a gate insulating film 10. Therefore, in the present process, the thickness of the surface semiconductor layer 4 is required to be defined in consideration of the thickness that is to be sacrificed in the process of forming the gate insulating film 10 (including the thickness of the gate insulating film 10 itself). That is, in the process of forming the gate insulating film 10, before the gate insulating film 10 itself is formed, for the purpose of ion implantation of impurities to the surface semiconductor layer 4, a sacrificial oxide film is formed on the front surface of the surface semiconductor layer 4 by thermal oxidation of the substrate 2A. Then, after that sacrificial oxide film is removed, the substrate 2A is again subjected to a thermal oxidation process to form the gate insulating film 10 on the front surface of the surface semiconductor layer 4. That is, the thickness of the surface semiconductor layer 4 left after the CMP process has to be defined in consideration of the fact that the thickness of the surface semiconductor layer 4 is reduced by the thickness of the sacrificial oxide film and the thickness of the gate insulating film 10.

For example, when the gate insulating film 10 of the IGBT is configured of a stacked film of an oxide film having a thickness of 10 nm formed by thermal oxidation and an oxide film having a thickness of 90 nm formed by CVD, if the thickness of the sacrificial oxide film and the thickness of the gate insulating film 10 are assumed to be 5 nm each, the thickness of the surface semiconductor layer 4 left after that CMP process can be 30 nm to 110 nm, for example. Also, since the thickness of the surface semiconductor layer 4 left after this CMP process is determined by a level difference by the insulating film 6, it goes without saying that the thin film part of the insulating film 6 has to be formed so that the thickness of the surface semiconductor layer 4 left after the CMP process becomes such a value as described above.

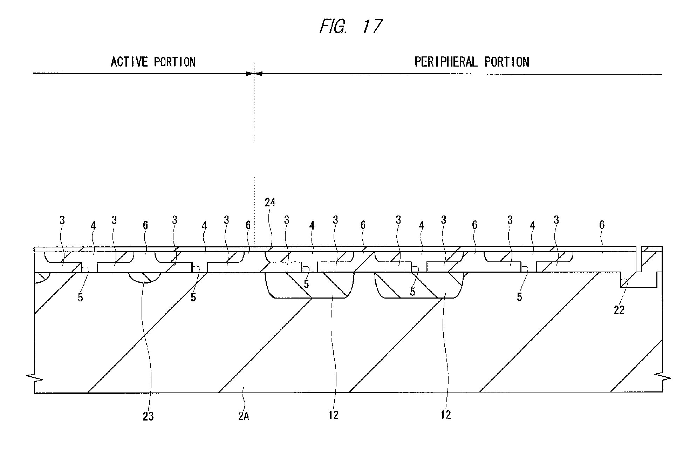

Next, as illustrated in FIG. 17, a thermal oxidation process is performed on the substrate 2A, thereby forming a sacrificial oxide film 24 on the surface of the surface semiconductor layer 4.

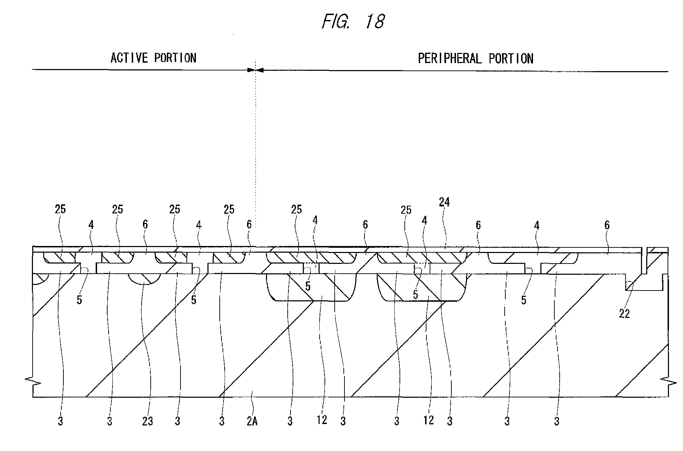

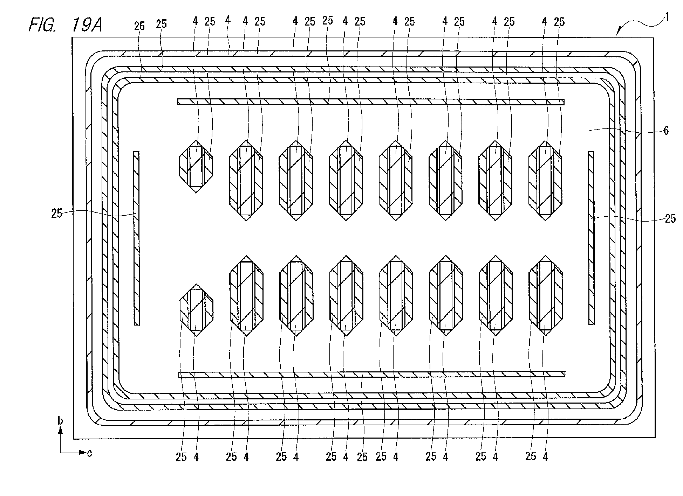

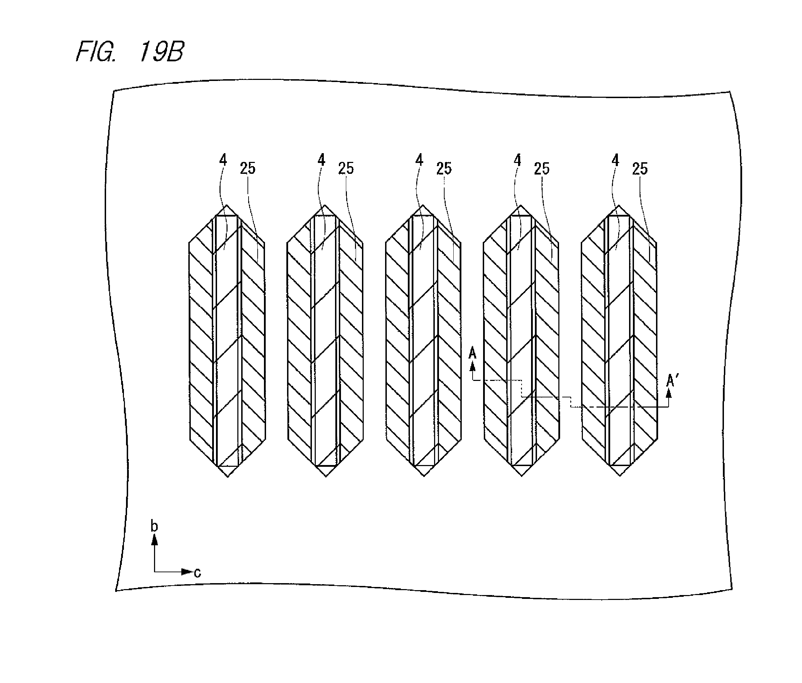

Next, as illustrated in FIG. 18, FIG. 19A, and FIG. 19B, with using a photoresist film patterned by photolithography as a mask, impurities exhibiting the p-type characteristics (for example, B (boron)) are introduced by ion implantation to a part of the region of the surface semiconductor layer 4 where an element of the IGBT is formed (a region serving as a channel below the gate electrode 11 formed in a subsequent process and its both sides), thereby forming the p-type semiconductor layer 25. Simultaneously, impurities exhibiting the p-type characteristics (for example, B (boron)) are introduced by ion implantation to a portion of the surface semiconductor layer 4 around the periphery of the active portion and a portion of the surface semiconductor layer 4 on the p-type field limiting ring 12 in the peripheral portion, thereby forming the p-type semiconductor layer 25.

The reason for forming the p-type semiconductor layer 25 in the surface semiconductor layer 4 where an element of the IGBT is formed prior to formation of the gate electrode 11 is as follows. That is, if impurities exhibiting the p-type characteristics are introduced to the surface semiconductor layer 4 with the gate electrode 11 as a mask after the gate electrode 11 is formed, a heat treatment at high temperature for a long time is required in order to diffuse the impurities to a region serving as a channel below the gate electrode 11. However, since this heat treatment exerts a stress on the thin film part of the insulating film 6 to cause a distortion, a shift in focusing in photolithography or a crystal defect occurs. To avoid this problem, the p-type semiconductor layer 25 is formed on the surface semiconductor layer 4 before the gate electrode 11 is formed in the active portion.

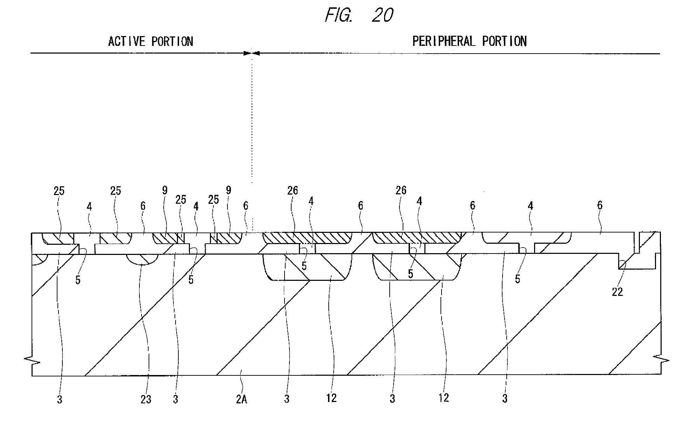

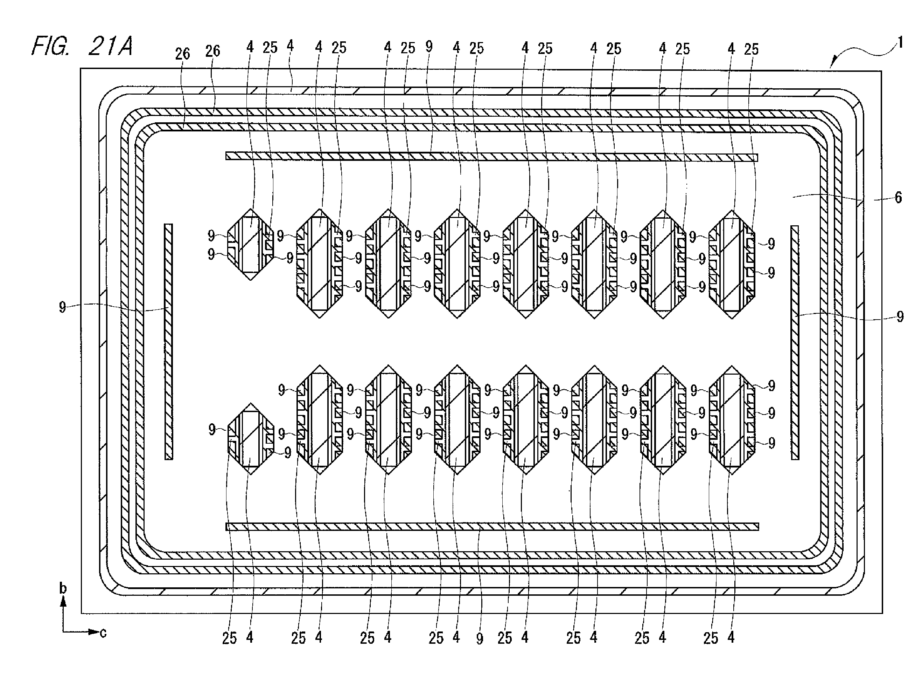

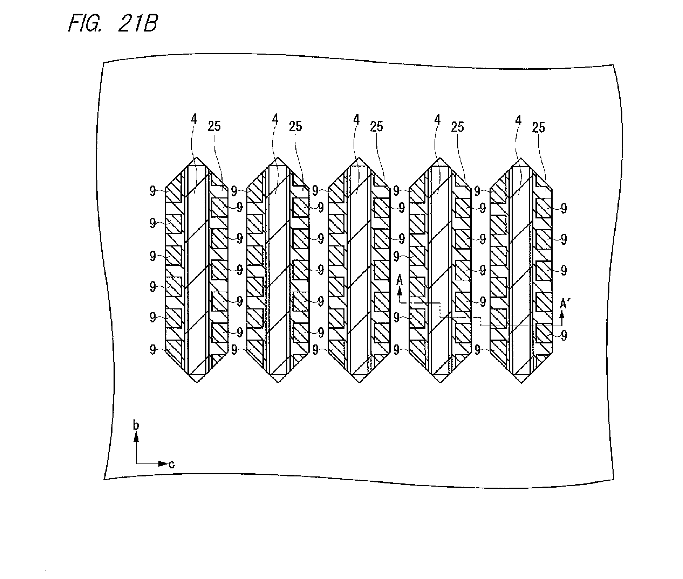

Next, as illustrated in FIG. 20, FIG. 21A, and FIG. 21B, with using a photoresist film patterned by photolithography as a mask, in a region where an element of the IGBT is formed, impurities exhibiting the p-type characteristics (for example, B (boron)) are introduced by ion implantation to a part of the region of the p-type semiconductor layer 25 (a region serving as an emitter (a back gate)), thereby forming the p⁺-type emitter layer 9 (p-type back gate layer). Simultaneously, impurities exhibiting the p-type characteristics (for example, B (boron)) are introduced by ion implantation to a portion of the p-type semiconductor layer 25 in the active region, thereby forming the p⁺-type emitter layer. Furthermore, simultaneously, impurities exhibiting the p-type characteristics (for example, B (boron)) are introduced by ion implantation to the p-type semiconductor layer 25 on the p-type field limiting ring 12 in the peripheral portion, thereby forming the p⁺-type semiconductor layer 26.

Here, while the p-type semiconductor layer 25 is left inside the p⁺-type emitter layer 9 in the region where an element of the IGBT is formed, the p⁺-type emitter layer 9 may be formed in the entire p-type semiconductor layer 25.

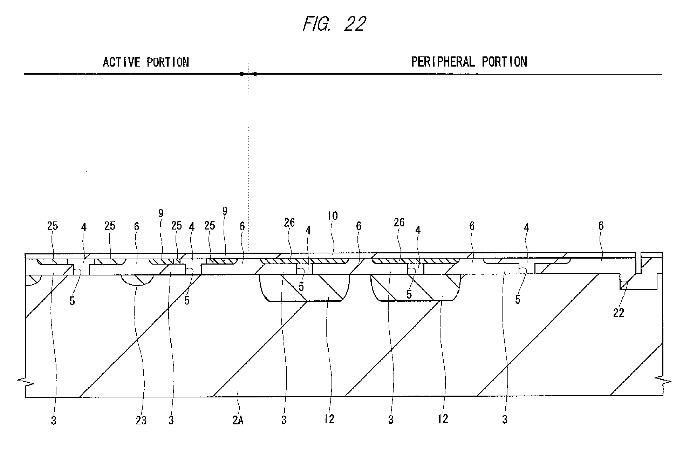

Next, as illustrated in FIG. 22, by performing a thermal oxidation process on the substrate 2A, a lower layer oxide film (omitted in the drawing) is formed on the front surface of the surface semiconductor layer 4 (also including the p-type semiconductor layer 25 and the p⁺-type emitter layer 9 in the active portion and the p⁺-type semiconductor layer 26 in the peripheral portion). Subsequently, an upper layer oxide film (omitted in the drawing) is deposited on this lower layer oxide film by CVD, thereby forming the gate insulating film 10 including the lower layer oxide film and the upper layer oxide film. The lower layer oxide film has a thickness of, for example, 10 nm, and the upper layer oxide film has a thickness of, for example, 90 nm

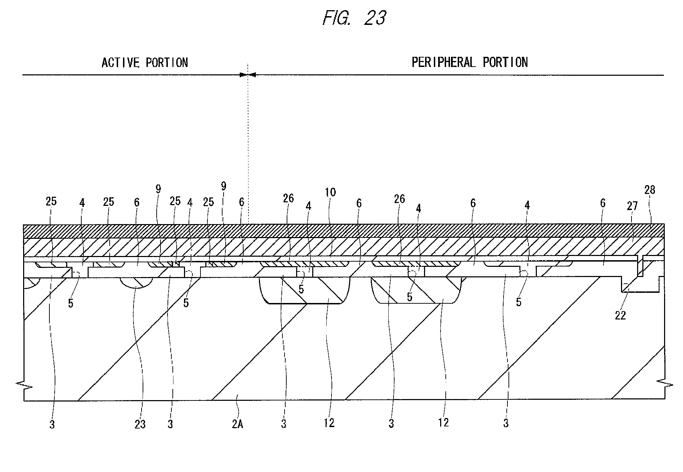

Next, as illustrated in FIG. 23, the polycrystalline silicon film 27 is deposited on the main surface of the substrate 2A, Subsequently, the tungsten silicide layer 28 is formed on the polycrystalline silicon film 27. The tungsten silicide layer 28 is formed in order to decrease the height of the gate electrode 11 to prevent the resistance of the gate electrode 1 from increasing.

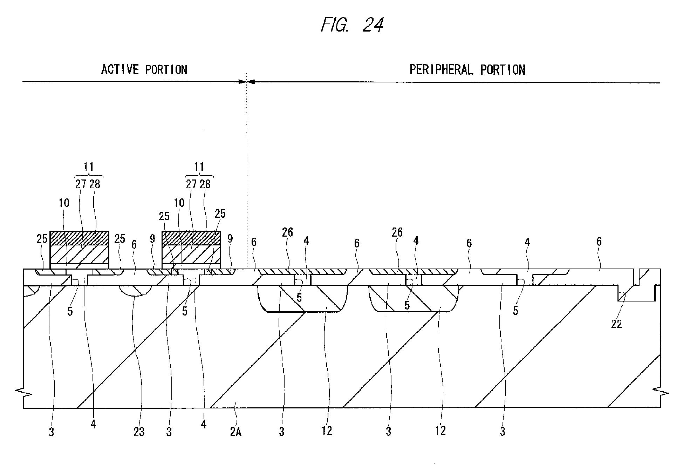

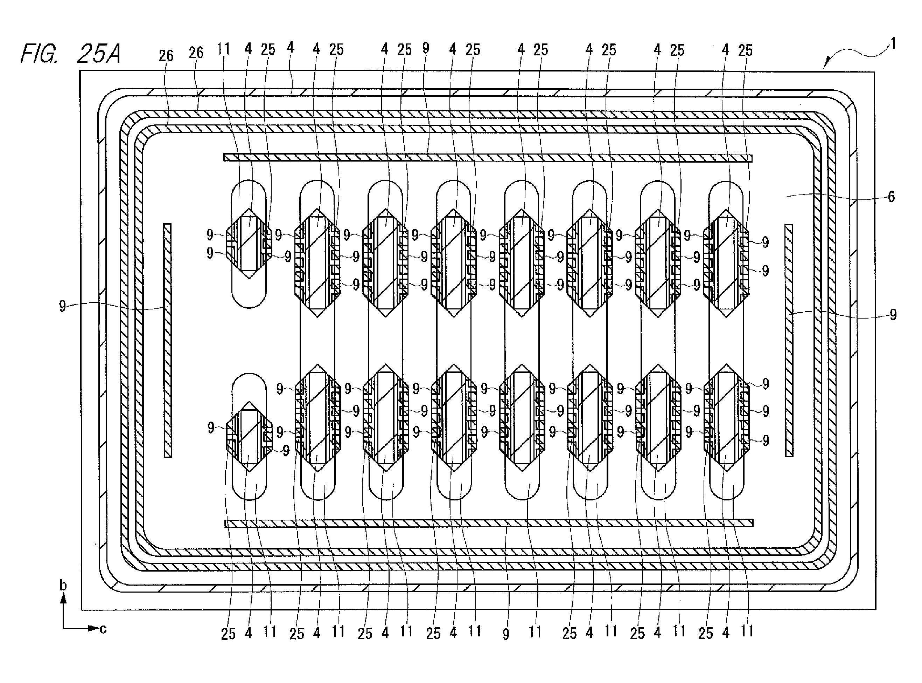

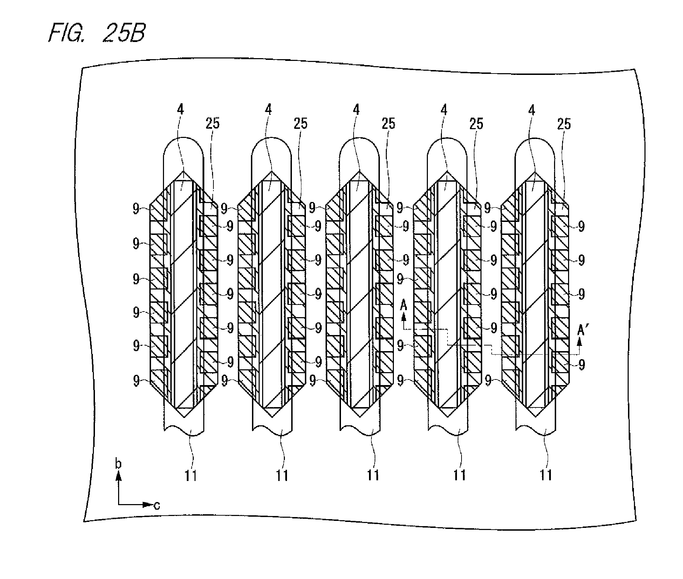

Next, as illustrated in FIG. 24, FIG. 25A, and FIG. 25B, by etching with a photoresist film patterned by photolithography as a mask, the tungsten silicide layer 28 and the polycrystalline silicon film 27 are sequentially patterned. In this manner, the gate electrode 11 formed of the stacked film including the polycrystalline silicon film 27 and the tungsten silicide layer 28 can be formed.

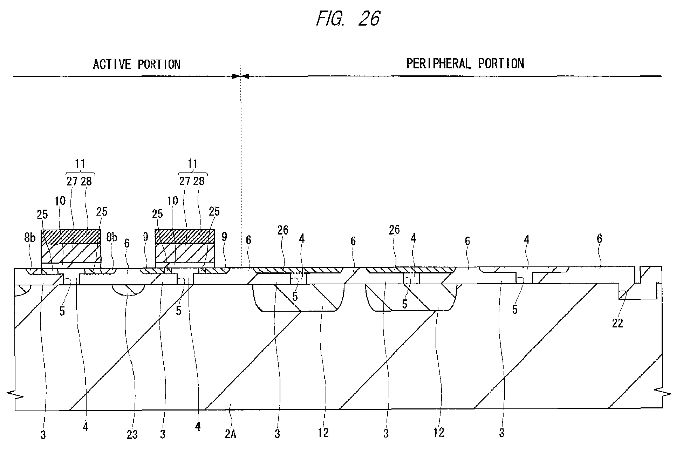

Next, as illustrated in FIG. 26, with using a photoresist film patterned by photolithography as a mask, impurities exhibiting the n-type characteristics (for example. As (arsenic)) are introduced by ion implantation to the p-type semiconductor layers 25 on both sides of the gate electrode 11 in the active portion, thereby forming the n⁻-type source layer 8b. Since this introduction of the impurities exhibiting the n-type prevents a crystal defect from occurring in the surface semiconductor layer 4 and the gate insulating film 10 below the side surfaces of the gate electrode 11, implantation energy and the amount of implantation in ion implantation are set to be relatively low.

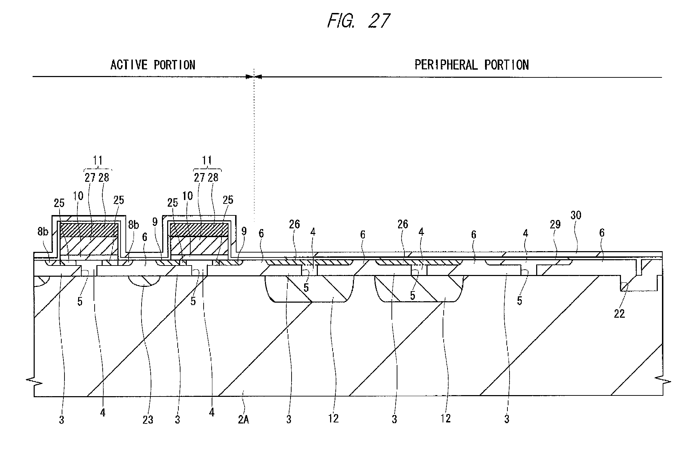

Next, as illustrated in FIG. 27, a silicon nitride film 29 is deposited on the main surface of the substrate 2A. Subsequently, an insulating film 30 formed of silicon oxide is deposited on the silicon nitride film 29.

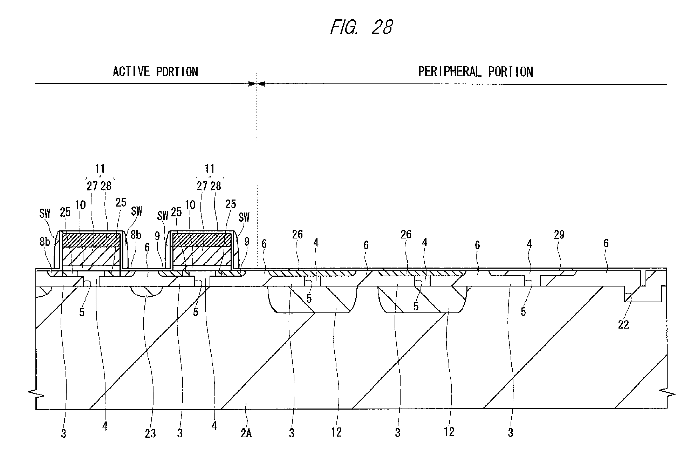

Next, as illustrated in FIG. 28, anisotropic dry etching is performed on the insulating film 30 using the silicon nitride film 29 as an etching stopper film, thereby forming side walls SW formed of the insulating film 30 on the side surfaces of the gate electrode 11.

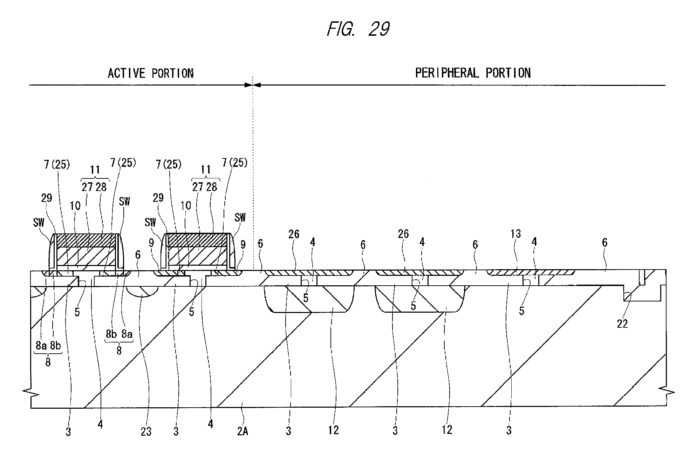

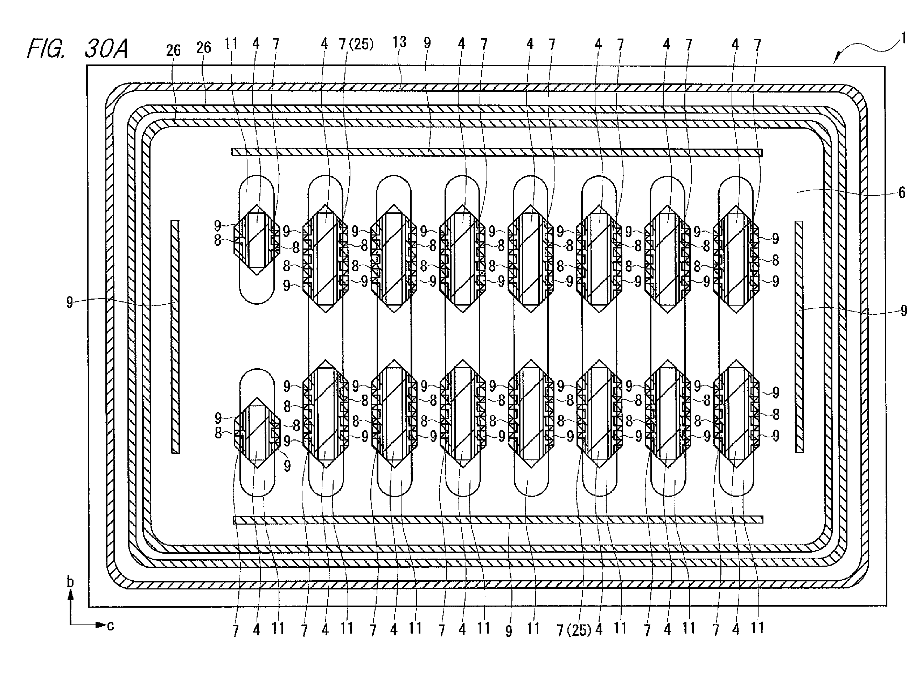

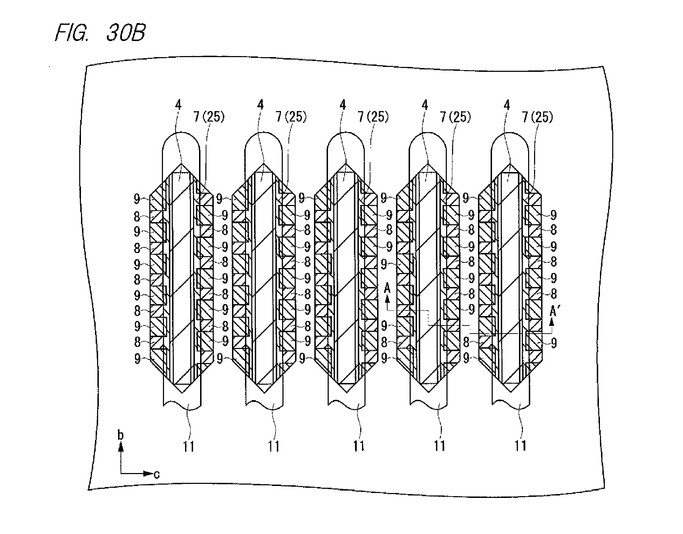

Next, as illustrated in FIG. 29, FIG. 30A, and FIG. 30B, with a photoresist film patterned by photolithography as a mask, impurities exhibiting the n-type characteristics (for example, As (arsenic)) are introduced by ion implantation to the n⁻-type source layer 8b on both sides of the gate electrode 11 in the active portion, thereby forming the n⁺-type source layer 8a having an impurity concentration higher than that of the n⁻-type source layer 8b described above. In this manner, the n-type source layer 8 formed of the n⁻-type source layer 8b and the n⁺-type source layer 8a is formed. Simultaneously, impurities exhibiting the n-type characteristics (for example, As (arsenic)) are introduced by ion implantation to the surface semiconductor layer 4 in the peripheral portion, thereby forming the n-type guard ring (a channel stopper) 13.

In the ion implantation of impurities to form the n⁺-type source layer 8a and others, the amount of implantation is increased more than that in the ion implantation of impurities to form the n⁻-type source layer 8b described above. In this mamer, even when impurities are introduced at a high concentration, impurities are ion-implanted at a distance equivalent to a side wall length of the side wall SW away from the side surface of the gate electrode 11. Therefore, by this introduction of the impurities exhibiting the n-type characteristics, it is possible to prevent a crystal defect from occurring in the surface semiconductor layer 4 and the gate insulating film 10 below the side surfaces of the gate electrode 11. Also, even if a crystal defects occurs in the surface semiconductor layer 4 below an end of the side wall SW, since it is away from any side surface of the gate electrode 11, this hardly influences the operation characteristics of the IGBT.

Meanwhile, in the region where an element of the IGBT is formed, it is impossible to form the n-type source layer 8 and the p⁺-type emitter layer 9 in the same cross section. For this reason, in a planar view, the n-type source layer 8 and the p⁺-type emitter layer 9 are alternately placed in one band-shaped region between the gate electrode 11 and the insulating film 6. Also, the p-type semiconductor layer 25 below the gate electrode 11 where the n-type source layer 8 or the p⁺-type emitter layer 9 is not formed configures the p-type channel layer 7.

According to the foregoing processes, the element of the IGBT according the first embodiment can be formed

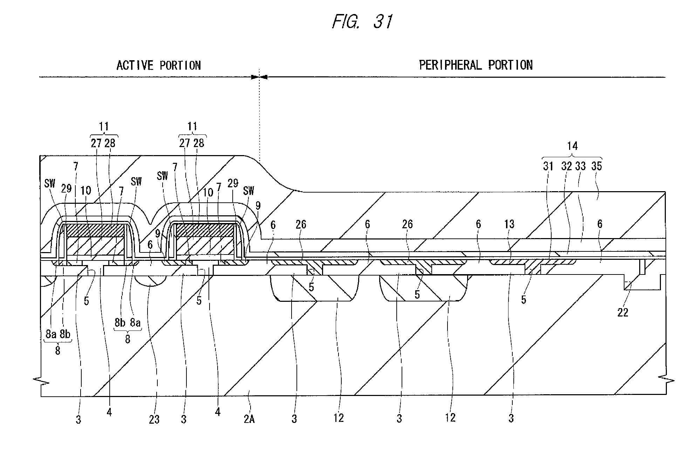

Next, as illustrated in FIG. 31, by performing a thermal oxidation process on the substrate 2A, the silicon oxide fihn 31 is formed on the main surface of the substrate 2A. Subsequently, the silicon nitride fihn 32, the silicon oxide film 33, and the stacked layer insulating film 35 formed of the PSG film and the SOG film are sequentially deposited, thereby forming the interlayer insulating film 14 formed of these insulating layers. The silicon oxide film 31 has a thickness of, for example, 10 to 30 nm; the silicon nitride film 32 has a thickness of, for example,10 to 50 nm; the silicon oxide film 33 has a thickness of, for example, 100 to 300 nm; and the stacked layer insulating film 35 formed of the PSG film and the SOG film has a thickness of, for example, 200 to 500 nm. In place of the stacked layer insulating film 35 formed of the PSG film and the SOG film, a BPSG (Boron-PSG) film, a stacked layer insulating film formed of a PSG film and a BPSG film, or an stacked layer insulating film formed of a BPSG film and an SOG film may be formed.

Then, a heat treatment is performed on the substrate 2A to bake the SOG film described above. According to this heat treatment, the impurities in the p⁺-type semiconductor layer 26 formed on the surface semiconductor layer 4 on the p-type field limiting ring 12 in the peripheral portion are diffused to be introduced also into the surface semiconductor layer 4 (the opening 5) between the p-type field limiting ring 12 and the p⁺-type semiconductor layer 26, and thus the p-type field limiting ring 12 and the p⁺-type semiconductor layer 26 are connected to each other with a low resistance. Similarly, the impurities in the n-type guard ring 13 in the peripheral portion are diffused to be introduced also into the surface semiconductor layer 4 (the opening 5) between the n-type guard ring 13 and the substrate 2A, and thus the n-type guard ring 13 and the substrate 2A are connected to each other with a low resistance.

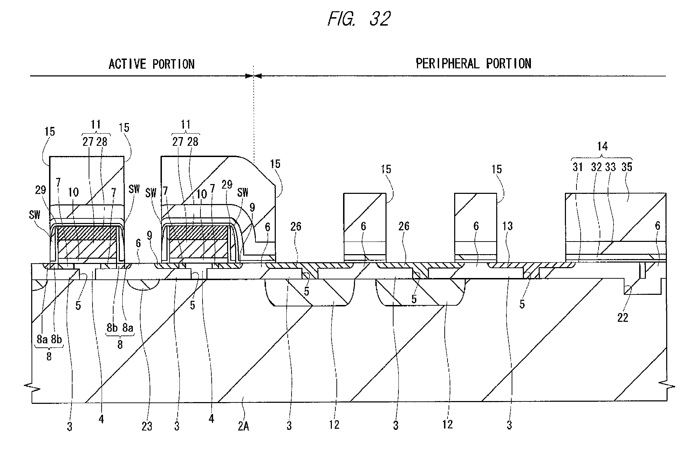

Next, as illustrated in FIG. 32, with a photoresist film patterned by photolithography as a mask, the interlayer insulating film 14 is etched to form an opening 15 reaching the n⁺-type source layer 8a and the p⁺-type emitter layer 9 of an element of the IGBT, the gate electrode 11, the p⁺-type emitter layer 9 around the perimeter of the active portion, the p⁺-type semiconductor layer 26, and the n-type guard ring 13 is formed.

To form this opening 15, with using the silicon nitride film 32 as an etching stopper, the stacked layer insulating film 35 formed of the PSG film and the SOG film and the silicon oxide film 33 are first etched sequentially. Subsequently, with using the silicon oxide film 31 as an etching stopper, the silicon nitride film 32 is etched. Then, the silicon oxide film 31 is etched using the n⁺-type source layer 8a, the p⁺-type emitter layer 9, the p⁺-type semiconductor layer 26, and the n-type guard ring 13 formed of single crystal silicon, and the tungsten silicide layer 28 configuring an upper part of the gate electrode 11 as etching stoppers.

Etching of the stacked layer insulating film 35 formed of the PSG film and the SOG film and the silicon oxide film 33 is once stopped in the silicon nitride film 32, and then the silicon nitride film 32 and the silicon oxide film 31 that are relatively thin are sequentially etched to form the opening 15. Therefore, the amount of over-etching of the n⁺-type source layer 8a, the p⁺-type emitter layer 9, the p⁺-type semiconductor layer 26, and the n-type guard ring 13 can be made subtle. Therefore, etching going through the n⁺-type source layer 8a, the p⁺-type emitter layer 9, the p⁺-type semiconductor layer 26, and the n-type guard ring 13 onto the buried insulating film 3 therebelow is prevented, and thus the opening 15 does not reach the substrate 2A.

Also, in the first embodiment, the gate electrode 11 is formed of a stacked film of the polycrystalline silicon film 27 and the tungsten silicide layer 28 to relatively decrease the height of the gate electrode 11. If the gate electrode 11 is formed only of the polycrystalline silicon film 27 without using the tungsten silicide layer 28, the polycrystalline silicon film 27 is required to be formed so as to be relatively thick for the purpose of decreasing resistance of the gate electrode 11. However, if the polycrystalline silicon film 27 becomes thicker, a surface step height (surface undulation) of the interlayer insulating film 14 is increased, which may have a risk of an occurrence of defocus in a photolithography process or an etching defect in an etching process when the opening 15 is formed In the first embodiment, the height of the gate electrode 11 is made to be relatively low, and therefore the etching defect described above can be avoided

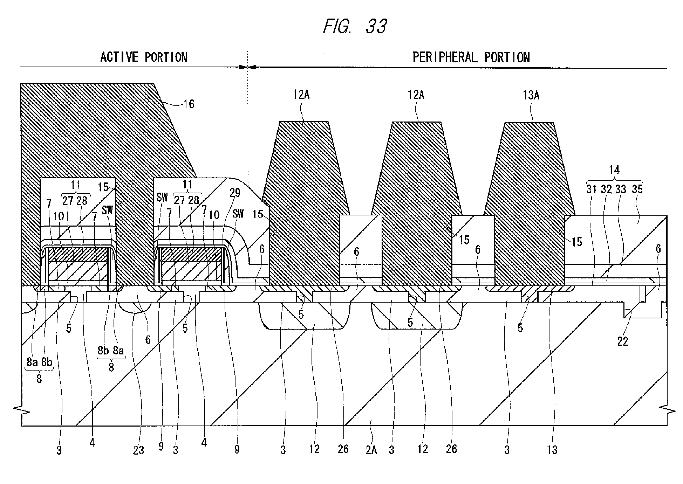

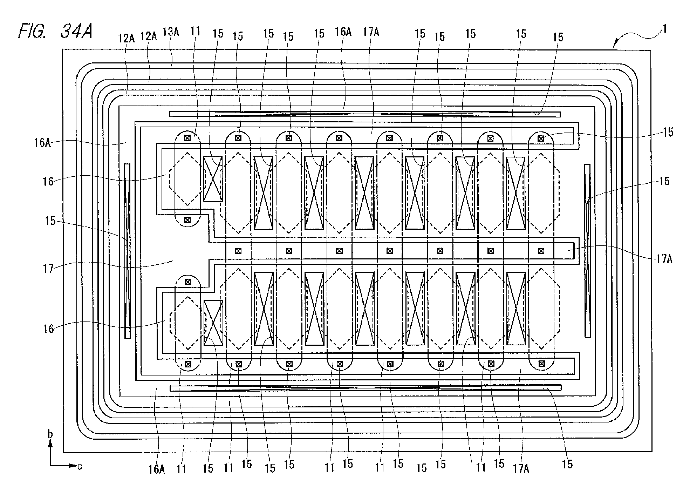

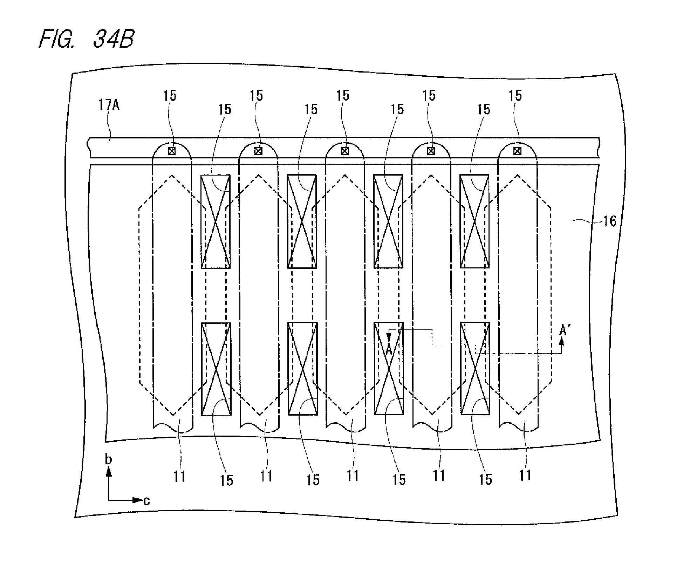

Next, as illustrated in FIG. 33, FIG. 34A, and FIG. 34B, an A1 (aluminum) film is deposited by, for example, sputtering, on the main surface of the substrate 2A. Next, using a photoresist film patterned by photolithography as a mask, that A1 film (aluminum) film is etched. In this manner, the source pad (the source electrode) 16 electrically connected to the n⁺-type source layer 8a and the p⁺-type emitter layer 9 of an element of the IGBT and the source routing electrode 16A electrically connected to the source pad 16 and having a pattern successive to the source pad 16 are formed. Also, the gate pad 17 electrically connected to the gate electrode 11 and the gate fingers 17A electrically connected to the gate electrode 11 and having a pattern successive to the gate pad 17 are formed. Furthermore, the field limiting ring electrode 12A electrically connected to the p-type field limiting ring 12 via the p⁺-type semiconductor layer 26 and the guard ring electrode 13A electrically connected to the n-type guard ring 13 are formed.

Although not illustrated in the drawings, after the source pad 16, the source routing electrode 16A, the gate pad 17, the gate fingers 17A, the field limiting ring electrode 12A, and the guard ring electrode 13A are formed, a polyimide film is deposited as a surface protection film on the main surface of the substrate 2A. Subsequently, openings reaching the source pad 16, the gate pad 17, the field limiting ring electrode 12A and the guard ring electrode 13A are formed in this polyimide film. These openings are formed in order to be electrically connecting leads to corresponding the source pad 16, the gate pad 17, the field limiting ring electrode 12A, and the guard ring electrode 13A by using bonding wires, after the substrate 2A is divided into individual semiconductor chips 1 and the semiconductor chip 1 is mounted on a die pad of a lead frame.

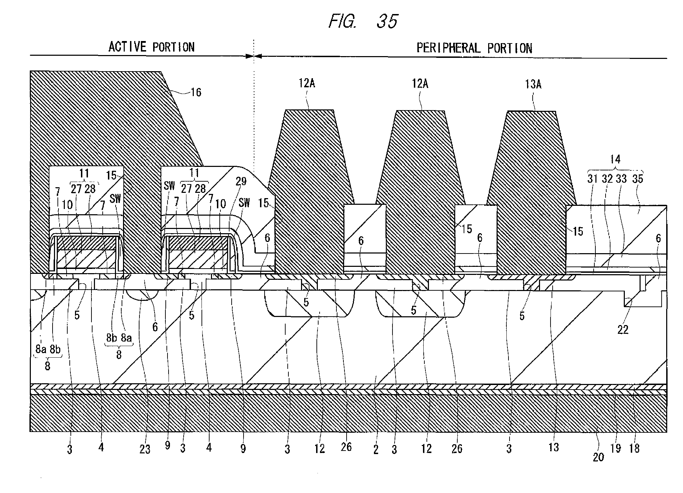

Next, as illustrated in FIG. 35, after a reinforcing member (omitted in the drawing) such as a foamable double sided tape or a glass reinforcing plate is laminated on the main surface of the substrate 2A, the rear surface of the substrate 2A is ground to form the base layer 2. As described above, the thickness of the base layer 2 is determined according to the withstand voltage of the IGBT. The rear surface of the substrate 2A is ground until it becomes 60 to 100 µm when the desired withstand voltage is 600 V and until it becomes 120 to 150 µm when the desired withstand voltage is 1200 V Since the reinforcing member is stacked on the main surface side of the substrate 2A, warpage or sag of the substrate 2A can be prevented.

Next, impurities exhibiting the n-type characteristics (for example, P (phosphorous)) and impurities exhibiting the p-type characteristics (for example, B (boron)) are sequentially introduced by ion implantation to the rear surface of the base layer 2, and these impurities are activated by using, for example, laser annealing, thereby forming the n-type buffer layer 18 and the p-type collector layer 19.

Next, a collector electrode 20 is formed on a rear surface of the base layer 2. This collector electrode 20 can be formed by stacking, in the order from a closer position from the p-type collector layer 19, an A1 (aluminum) film, a Ti (titanium) film, a Ni (nickel) film, and an Au (gold) film by, for example, sputtering or a vapor deposition method. Also, the collector electrode 20 may be obtained by stacking, in the order closer to the p-type collector layer 19, a Ni (nickel) film, a Ti (titanium) film, a Ni (nickel) film, and an Au (gold) film, or the collector electrode 20 may be obtained by stacking, in the order from a closer position to the p-type collector layer 19, a Ti (titanium) film, a Ni (nickel) film, and an Au (gold) film. Thereafter, the reinforcing member is removed.

Next, by cutting the substrate 2A along a dividing region (a dicing line), the substrate 2A is singulated into individual semiconductor chips 1. Subsequently, a lead frame is prepared, and after the semiconductor chip 1 obtained by separation is mounted on a die pad of the lead frame, each of the source pad 16, the gate pad 17, the field limiting ring electrode 12A, and the guard ring electrode 13A is electrically connected to a corresponding one of the leads by using bonding wires. Thereafter, the semiconductor chip 1, the lead frame, and the bonding wires are sealed with a sealing resin, thereby manufacturing the semiconductor device according to the first embodiment.

Note that an example has been described in which one end in the first direction of the active region AC where an element of the IGBT is formed is configured of the first short side S1 and the second short side S2 and the other end in the first direction of the active region AC where an element of the IGBT is formed is configured of the third short side S3 and the fourth short side S4. Furthermore, while the first angle θ1, the second angle θ2, the third angle θ3, and the fourth angle θ4 are all equal to each other (for example, 135 degrees) in the first embodiment described above, the angles are not restricted to these. For example, each of both ends in the first direction of the active region AC where an element of the IGBT is formed may be configured of three short sides. Also, the first angle θ1, the second angle θ2, the third angle θ3, and the fourth angle θ4 may be angles different from each other.

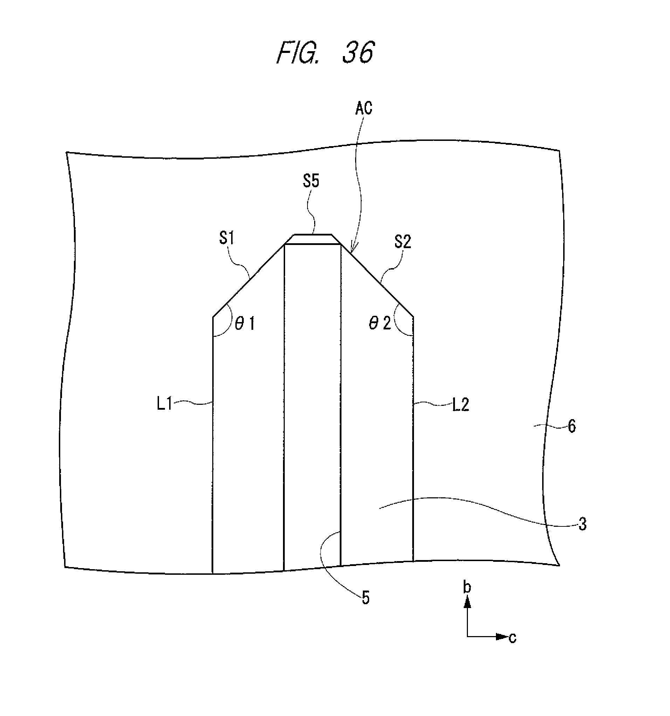

FIG. 36 depicts a modification example in which the end in the first direction of the active region AC where an element of the IGBT is formed is configured of three short sides. FIG. 36 is a plan view of main parts illustrating a part of the active portion of the semiconductor chip forming an IGBT (one end of the active region where an element of the IGBT is formed) being enlarged.

The shape of the end in the first direction (a 'b' direction in FIG. 36) of the active region AC in a plan view is a trapezoid having its center projecting. According to the shape of the single crystal silicon configuring the surface semiconductor layer 4 in epitaxial growth, the end in the first direction of the active region AC is configured of two short sides (a first short side S1 and a second short side S2) having an angle with respect to the first direction and one side (a fifth short side S5) positioned between these two short sides described above and orthogonal to the first direction. That is, the end in the first direction of the active region AC has the first short side S1 forming the first angle θ1 with the first long side L1, the fifth short side S5 connected to the first short side S1 and orthogonal to the first direction, and the second short side S2 connected to the fifth short side S5 and forming the second angle θ2 with the second long side L2, and the first angle θ1 and the second angle θ2 are in a range larger than 90 degrees and smaller than 180 degrees.

Also, while the active region AC where an element of the IGBT is formed is exemplarily taken as an active region to solve the problems in the first embodiment described above and its structure has been described in detail, it goes without saying that this is not meant to be restrictive.

The structure of the active region according to the first embodiment described above can also be applied to the active region AC formed around the perimeter of the active portion (formed between the active portion and the peripheral portion), for example, the active region AC where the p⁺-type emitter layer 9 to which the source routing electrode 16A is electrically connected is formed.

For example, as illustrated in FIG. 8A and FIG. 10A described above, unlike the planar shape of the active region AC where an element of the IGBT in the active portion is formed, the active region AC around the perimeter of the active portion (formed between the active portion and the peripheral portion) and where the p⁺-type emitter layer 9 is later formed has a quadrangular planar shape formed of long sides and short sides in a planar view. According to the shape of the active regionAC, the opening 5 is formed.

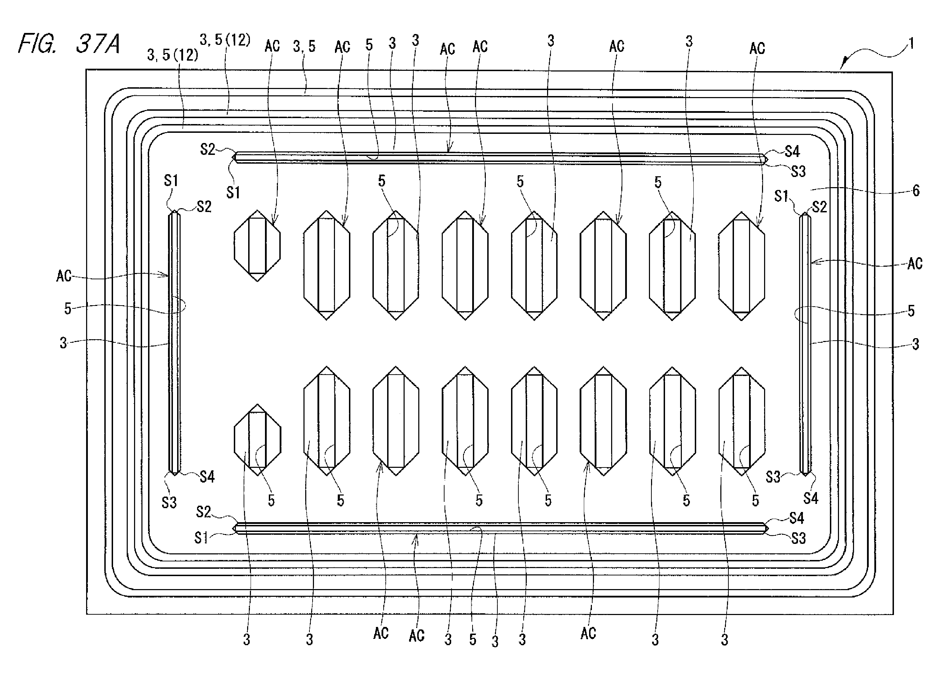

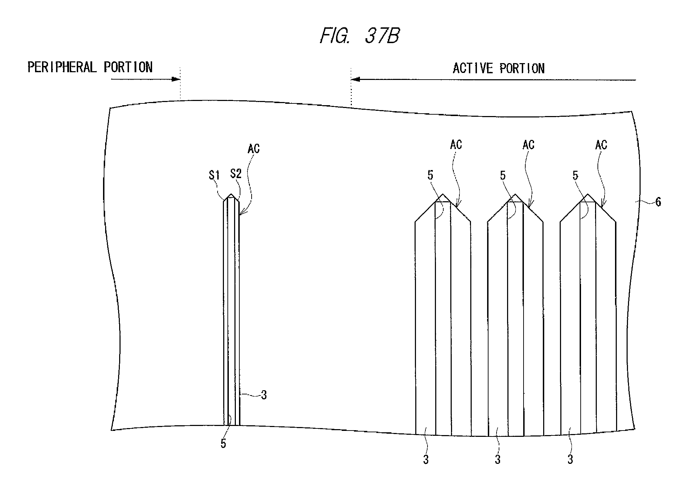

However, as illustrated in FIG. 37A and FIG. 37B, the active region AC around the perimeter of the active portion (formed between the active portion and the peripheral portion) and where the p⁺-type emitter layer 9 is later formed may have a planar shape similar to the planar shape of the active region AC where an element of the IGBT in the active portion is formed.

For example, the active region AC around the perimeter of the active portion (formed between the active portion and the peripheral portion) and where the p⁺-type emitter layer 9 is later formed is a region having long sides and short sides, one end is configured of the first short side S1 and the second short side S2, and the other end is configured of the third short side S3 and the fourth short side S4.

In this manner, according to the first embodiment, the active region AC can be filled with the surface semiconductor layer 4 without a gap. Therefore, the occurrence of contamination and a foreign substance and an inconvenience in photolithography can be avoided, and a manufacture yield of semiconductor devices each including an IGBT can be improved.

### (Second Embodiment)

A semiconductor device including an IGBT according to a second embodiment has a feature in an active region formed in a peripheral portion (a part inside each side of the semiconductor chip) between each side of a semiconductor chip and an active portion where an element of the IGBT is formed in a planar view, specifically, an active region where a p⁺-type semiconductor layer connected to a p-type field limiting ring is formed, and a feature in an active region where an n-type guard ring is formed.

### <<Semiconductor Device>>

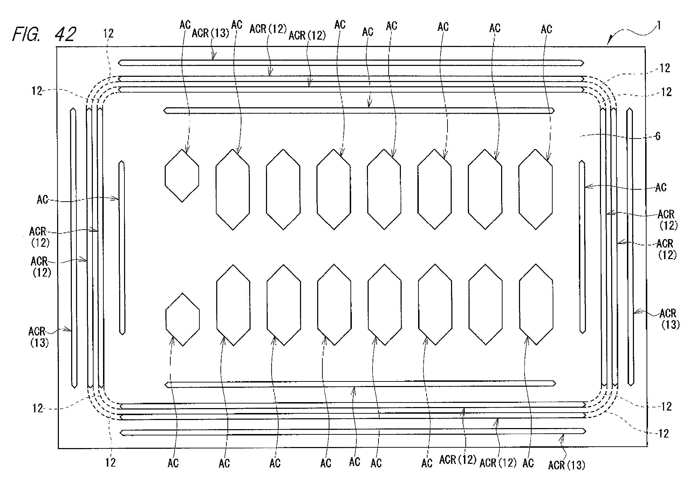

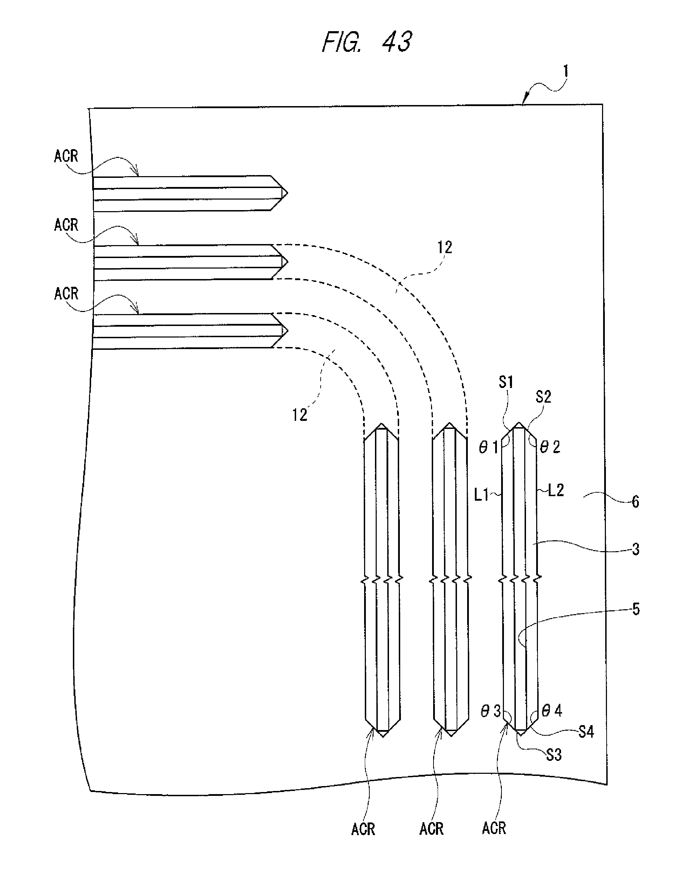

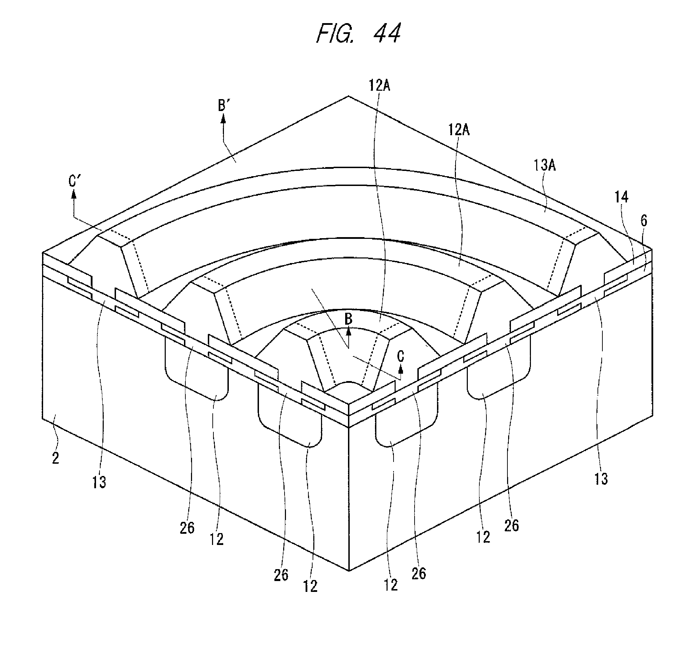

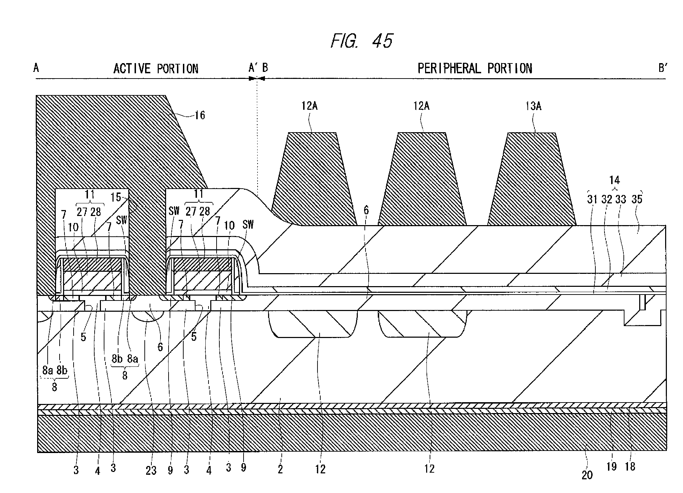

A semiconductor device including an IGBT according to a second embodiment will be described with reference to FIG. 42 to FIG. 45. FIG. 42 is a plan view of main parts illustrating active regions formed on a semiconductor chip. FIG. 43 is a plan view of main parts illustrating a portion of an active region formed in a peripheral portion of the semiconductor chip being partially enlarged. FIG. 44 is a perspective view of a portion of the peripheral portion near a comer of the semiconductor chip. FIG. 45 is a cross-sectional view of main parts illustrating the active portion of the semiconductor chip and a portion of the peripheral portion near the corner of the semiconductor chip (as for the active portion, a cross-sectional view of main parts corresponding to a cross section along the A-A' line illustrated in FIG. 1B described above; as for the peripheral portion, a cross-sectional view of main parts corresponding to a cross section along the B-B' line of FIG. 44). Note that the structure of the active portion of the semiconductor chip where an element of the IGBT is formed is similar to that in the first embodiment described above, and therefore its description is omitted herein.

As illustrated in FIG. 42 and FIG. 43, as with the first embodiment descried above, a plurality of p-type field limiting rings 12 are formed in a peripheral portion of a semiconductor chip 1 so as to surround an active portion where an element of the IGBT is formed in a planar view. Furthermore, an n-type guard ring 13 is formed between the plurality of p-type field limiting rings 12 and each side of the semiconductor chip 1. While an example is illustrated in FIG. 42 and FIG. 43 in which two p-type field limiting rings 12 are formed, many more may be formed.

However, unlike the first embodiment described above, an active region ACR where a p⁺-type semiconductor layer 26 connected to the p-type field limiting ring 12 is formed and an active region ACR where the n-type guard ring 13 is formed are neither formed on portions in the peripheral portion near a corner of the semiconductor chip 1 nor formed in a ring shape in which the regions are connected as one so as to surround the active portion where an element of the IGBT is formed. The active regions ACR are band-shaped patterns each having a predetermined width (for example, 2 µm to 3 µm) in a planar view and extending along each side of the semiconductor chip 1.

Furthermore, the shape of both ends of each active region ACR in the planar view forms a triangle having its center projecting. According to the shape of the single crystal silicon in epitaxial growth, both ends of the active region ACR are each configured of two short sides, and the two short sides each have an angle with respect to each side of the semiconductor chip 1.

That is, the active region ACR has a first long side L1 extending along one side of the semiconductor chip 1 and a second long side L2 extending along the above-mentioned side of the semiconductor chip 1 between the above-mentioned side of the semiconductor chip 1 and the first long side L1 having a predetermined distance (for example, 2 µn to 3 µm) apart from the first long side L1 in a planar view. Furthermore, one end of each of the first long side L1 and the second long side L2 has a first short side S1 forming a first angle θ1 with the first long side L1 and a second short side S2 forming a second angle θ2 with the second long side L2. The other end of each of the first long side L1 and the second long side L2 has a third short side S3 forming a third angle θ3 with the first long side L1 and a fourth short side S4 forming a fourth angle θ4 with the second long side L2. The first angle θ1, the second angle θ2, the third angle θ3, and the fourth angle θ4 are in a range larger than 90 degrees and smaller than 180 degrees. Therefore, as with the first embodiment described above, a surface semiconductor layer 4 can be formed in this active region ACR without forming a gap between an insulating film 6 defining the active region ACR and the surface semiconductor layer 4 (refer to FIG. 12 to FIG. 14 described above).

The four corners of the opening 5 formed in a buried insulating film 3 are formed so as to be in contact with the first short side S1, the second short side S2, the third short side S3, and the fourth short side S4, respectively, of the active region ACR in the planar view.

On the other hand, a p-type field limiting ring 12 is formed in a ring shape in which the whole is connected as one so as to surround the active portion in the planar view. Therefore, the p-type field limiting ring 12 is formed to have a first radius of curvature in the planar view so as to surround the active portion where an element of the IGBT is formed also in the peripheral portion near the corner of the semiconductor chip 1.

Also, as illustrated in FIG. 44, a field limiting ring electrode 12A connected to a p⁺-type semiconductor layer 26 is formed in a ring shape in which the whole is connected as one so as to overlap the p-type filed limiting ring 12 above the p-type field limiting ring 12 in the planar view. Therefore, the field limiting ring electrode 12A is configured of four band-shaped portions extending along four sides, respectively, of the semiconductor chip 1 and four rounded-shaped portions connecting adjacent two band-shaped portions (round parts, corner parts, or curved parts). The round parts of the field limiting ring electrode 12A have a second radius of curvature, and this second radius of curvature may be the same as the first radius of curvature of the p-type field limiting ring 12.

Furthermore, a guard ring electrode 13A connected to the n-type guard ring 13 is formed in a ring shape in which the whole is connected as one so as to be away from the field limiting ring electrode 12A and to surround the field limiting ring electrode 12A in a planar view. Therefore, the guard ring electrode 13A is configured of four band-shaped portions extending along the four sides, respectively, of the semiconductor chip 1 and four rounded-shaped portions (the round parts, the corner parts, or the curved parts) each connecting adjacent two band-shaped portions. The round part of the guard ring electrode 13A is formed so as to have a third radius of curvature in a planar view.

Therefore, regions in the peripheral portion of the semiconductor chip 1 where the active regions ACR are formed (the band-shaped portions of the field limiting ring electrode 12A and the guard ring electrode 13A) each have a cross section (a cross section along a C-C' line in FIG. 44) that is similar to the cross section illustrating the peripheral portion of the semiconductor chip 1 illustrated in FIG. 2 described above.

By contrast, regions in the peripheral portion closer to the corners of the semiconductor chip 1 where no active regions ACR are formed (the round parts of the field limiting ring electrode 12A and the guard ring electrode 13A) each have a cross section (a cross section along a B-B' line in FIG. 44) indicating the peripheral portion of the semiconductor chip 1 illustrated in FIG. 45. In these regions where no active regions ACR are formed, while the p-type field limiting ring 12 is formed by introducing impurities exhibiting the p-type characteristics to the base layer 2, the p-type field limiting ring 12 is not connected to the field limiting ring electrode 12A. Also, the n-type guard ring 13 is not connected to the guard ring electrode 13A.

In this manner, in the round parts of the field limiting ring electrode 12A and the guard ring electrode 13, the field limiting ring electrode 12A and the p-type field limiting ring 12 are not connected to each other and the guard ring electrode 13A and the n-type guard ring 13 are not connected to each other, thereby avoiding an electric field concentration at the round part of the field limiting ring electrode 12A and the guard ring electrode 13A.

Meanwhile, in a region where the p-type field limiting ring 12 and the field limiting ring electrode 12A are not connected to each other, it is worried that a difference in potential therebetween may be large. Similarly, in a region where the n-type guard ring 13 and the guard ring electrode 13A are not connected to each other, it is worried that a difference in potential therebetween may be large. To address this, in a region where round parts of the field limiting ring electrode 12A and the guard ring electrode 13A are formed, one or two or more quadrangular active regions placed like islands may be formed and, via this active region, the p-type field limiting ring 12 and the field limiting ring electrode 12A may be connected to each other and the base layer 2 and the guard ring electrode 13A may be connected to each other.

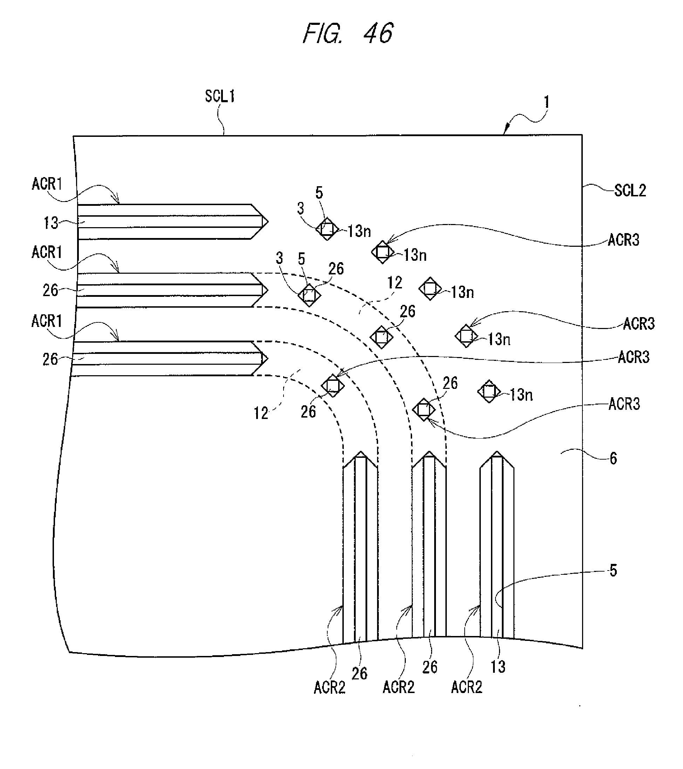

By using FIG. 46, a modification example is described in which one or two or more quadrangular active regions are arranged like islands in the region where round parts of the field limiting ring electrode 12A and the guard ring electrode 13A are formed. FIG. 46 is a plan view of main parts of partially enlarged active regions formed in the peripheral portion of the semiconductor chip.

Active regions ACR1 each extending in a band shape along a first side SCL1 of the semiconductor chip 1 and active regions ACR2 each extending in a band shape along a second side SCL2 orthogonal to the first side SCL1 of the semiconductor chip 1 are formed. These active regions ACR1 and ACR2 are similar to the active regions ACR described by using FIG. 42 and FIG. 43 described above.

The p-type field limiting ring 12 is formed in a ring shape so as to surround the active portion where an element of the IGBT is formed. Although not shown in the drawings, the field limiting ring electrode 12A is formed above the p-type field limiting ring 12 so as to overlap the p-type field limiting ring 12 in the planar view. Furthermore, the guard ring electrode 13A is formed away from the p-type field limiting ring 12 so as to surround the field limiting ring electrode 12A in the planar view (for example, see FIG. 44 described above).

In a region in the peripheral portion near a corner of the semiconductor chip 1 where the round part of the field limiting ring electrode 12A is formed, one or two or more quadrangular-shaped active regions ACR3 are placed like islands so as not to run off the p-type field limiting ring 12 in the planar view. In a region where these active regions ACR3 are formed, each p-type field limiting ring 12 is connected to the p⁺-type semiconductor layer 26 formed in the active region ACR3 through an opening 5 formed in a buried insulating film 3. Furthermore, although not illustrated in the drawings, through an opening formed in an interlayer insulating film, the field limiting ring electrode 12A is connected to the p⁺-type semiconductor layer 26, and the p-type field limiting ring 12 has its voltage fixed by the field limiting ring electrode 12A.

Similarly, also in a region where a round part of the guard ring electrode 13A in the peripheral portion near a corner of the semiconductor chip 1, one or two or more quadrangular-shaped active regions ACR3 are arranged like islands. In each of these active regions ACR3, an n⁺-type semiconductor layer 13n of a layer identical to that of the n-type guard ring 13 is formed, and the n⁺-type semiconductor layer 13n is connected to the base layer 2 through the opening 5 formed in the buried insulating film 3. Furthermore, although not illustrated in the drawings, through an opening formed in the interlayer insulating film, the guard ring electrode 13A is connected to the n⁺-type semiconductor layer 13n, and the n⁺-type semiconductor layer 13n has its voltage fixed by the guard ring electrode 13A.

The shape of each active region ACR3 is, for example, a quadrangular shape in a planar view. As with the first embodiment described above, the active region ACR3 has sides each having an angle with respect to each side of the semiconductor chip 1 (for example, a first side SCL1 and a second side SCL2). A surface semiconductor layer (the p⁺-type semiconductor layer 26 and the n⁺-type semiconductor layer 13n) can be formed in this active region ACR3 without forming a gap between an insulating film 6 defining the active region ACR3 and the p⁺-type semiconductor layer 26 or the n⁺-type semiconductor layer 13n.

The opening 5 formed in the active region ACR3 is formed such that four corners of the opening 5 formed in the buried insulating film 3 are in contact with respective sides of the active region ACR3 in the planar view. Also, the opening 5 is formed so that the each side is parallel or orthogonal to a relevant one of the sides of the semiconductor chip 1 (for example, the first side SCL1 or the second side SCL2).

As described in the foregoing, according to the second embodiment, effects similar to those in the first embodiment described above can be obtained even in an active region formed in the peripheral portion of the semiconductor chip 1. Furthermore, since electric field concentration can be avoided in the round part of the field limiting ring electrode 12A and the guard ring electrode 13A, reliability of the semiconductor device including an IGBT can be improved.

The present invention includes at least the following embodiments.

### [Note 1]

A semiconductor device including an IGBT, including:
(a) a semiconductor substrate;
(b) a buried insulating film having a first thickness formed on the semiconductor substrate;
(c) an opening formed in the buried insulating film;
(d) an insulating film having a second thickness larger than the first thickness formed around a perimeter of the buried insulating film so as to define an active region;
(e) a surface semiconductor layer formed on the buried insulating film in the active region; and
(f) an electrode connected to the surface semiconductor layer, in which
the active region has a first long side extending in a first direction and a second long side in the first direction having a predetermined distance apart from the first long side in a second direction orthogonal to the first direction in a planar view,
one end of the first long side has a first short side forming a first angle with the first long side and one end of the second long side has a second short side forming a second angle with the second long side, and the other end of the first long side has a third short side forming a third angle with the first long side and the other end of the second long side has a fourth short side forming a fourth angle with the second long side, and
the first angle, the second angle, the third angle, and the fourth angle are in a range larger than 90 degrees and smaller than 180 degrees.

### [Note 2]

The semiconductor device according to Note 1, in which
the first angle, the second angle, the third angle, and the fourth angle are 135 degrees.

### [Note 3]

The semiconductor device according to Note 1, in which
a crystal plane of an upper surface of the surface semiconductor layer is a (100) plane, and the surface semiconductor layer has crystal planes in contact with the first short side, the second short side, the third short side, and the fourth short side of the active region, each of which is either one of a (111) plane and a (111) equivalent family plane.

### [Note 4]

The semiconductor device according to Note 1, in which
the opening has a quadrangular shape in a planar view, and is formed so that corners of the opening are in contact with the first short side, the second short side, the third short side, and the fourth short side of the active region, respectively, in a planar view.

### [Note 5]

The semiconductor device according to Note 1, in which
the semiconductor substrate and the surface semiconductor layer are formed from single crystal silicon.

### [Note 6]

The semiconductor device according to Note 1, in which
the electrode is any one of a field limiting ring electrode, a guard ring electrode, and a source routing electrode.

In the foregoing, the invention made by the inventors of the present invention has been concretely described based on the embodiments. However, it is needless to say that the present invention is not limited to the foregoing embodiments and various modifications and alterations can be made within the scope of the present invention.

## Claims

1. A semiconductor device including an IGBT, comprising:
(a) a collector layer having a first conductive type of the IGBT;
(b) a buffer layer of the IGBT having a second conductive type that is different from the first conductive type and formed on the collector layer;
(c) a base layer of the IGBT having the second conductive type formed on the buffer layer;
(d) a plurality of buried insulating films each having a first thickness formed on the base layer;
(e) an opening formed in each of the buried insulating films;
(f) an insulating film formed around the plurality of buried insulating films, having a second thickness thicker than the first thickness, and defining a plurality of active regions;
(g) a surface semiconductor layer having the second conductive type formed on each of the plurality of buried insulating films in the plurality of active regions;
(h) a channel layer of the IGBT having the first conductive type formed in the surface semiconductor layer;
(i) an emitter layer of the IGBT having the first conductive type formed in the surface semiconductor layer so as to be in contact with the channel layer and having a concentration larger than a concentration of the channel layer;
(j) a source layer of the IGBT having the second conductive type formed in the surface semiconductor layer;
(k) a gate insulating film of the IGBT selectively formed on a part of a surface of the surface semiconductor layer;
(l) a gate electrode of the IGBT formed on the gate insulating film;
(m) a collector electrode of the IGBT formed on a rear surface of the collector layer and electrically connected to the collector layer; and
(n) a source electrode of the IGBT formed on the emitter layer and the source layer and electrically connected to the emitter layer and the source layer,
wherein the active region has a first long side extending in a first direction and a second long side in the first direction having a predetermined distance apart from the first long side in a second direction orthogonal to the first direction in a planar view,
one end of the first long side has a first short side forming a first angle with the first long side and one end of the second long side has a second short side forming a second angle with the second long side, and the other end of the first long side has a third short side forming a third angle with the first long side and the other end of the second long side has a fourth short side forming a fourth angle with the second long side, and
the first angle, the second angle, the third angle, and the fourth angle are in a range larger than 90 degrees and smaller than 180 degrees.

2. The semiconductor device according to claim 1,
wherein the first angle, the second angle, the third angle, and the fourth angle are 135 degrees.

3. The semiconductor device according to claim 1,
wherein a crystal plane of an upper surface of the surface semiconductor layer is a (100) plane, and the surface semiconductor layer has crystal planes in contact with the first short side, the second short side, the third short side, and the fourth short side of the active region, each of which is either one of a (111) plane and a (111) equivalent family plane.

4. The semiconductor device according to claim 1,
wherein the opening has a quadrangular shape in a planar view, and is formed so that corners of the opening are in contact with the first short side, the second short side, the third short side, and the fourth short side of the active region, respectively, in a planar view.

5. The semiconductor device according to claim 1,
wherein the semiconductor substrate and the surface semiconductor layer are formed from single crystal silicon.

6. The semiconductor device according to claim 1,
wherein the first long side and the second long side are each longer than the first short side, the second short side, the third short side, and the fourth short side.

7. The semiconductor device according to claim 1,
wherein lengths of the first short side, the second short side, the third short side, and the fourth short side are the same.

8. A semiconductor device including an IGBT, comprising:
a quadrangular-shaped semiconductor chip having a first side and a second side orthogonal to the first side;
an active portion in which an element of the IGBT of the semiconductor chip is formed;
a first active region extending between the first side of the semiconductor chip and the active portion along the first side in a planar view; and
a second active region extending between the second side of the semiconductor chip and the active portion along the second side in a planar view,
wherein the first active region has a first long side extending along the first side of the semiconductor chip and a second long side extending between the first side of the semiconductor chip and the first long side along the first side of the semiconductor chip in a planar view,
one end of the first long side has a first short side forming a first angle with the first long side and one end of the second long side has a second short side forming a second angle with the second long side, and the other end of the first long side has a third short side forming a third angle with the first long side and the other end of the second log side has a fourth short side forming a fourth angle with the second long side,
the second active region has a third long side extending along the second side of the semiconductor chip and a fourth long side extending between the second side of the semiconductor chip and the third long side along the second side of the semiconductor chip in a planar view,
one end of the third long side has a fifth short side forming a fifth angle with the third long side and one end of the fourth long side has a sixth short side forming a sixth angle with the fourth long side, and the other end of the third long side has a seventh short side forming a seventh angle with the third long side and the other end of the fourth long side has an eighth short side forming an eighth angle with the fourth long side, and
the first to eighth angles are in a range larger than 90 degrees and smaller than 180 degrees.

9. The semiconductor device according to claim 8,
wherein the first to eighth angles are 135 degrees.

10. The semiconductor device according to claim 8, further comprising:
an interlayer insulating film formed on the first active region and the second active region; and
a wiring formed on the interlayer insulating film,
wherein the first active region is formed of a first semiconductor layer formed on a semiconductor substrate of a first conductive type via a first buried insulating film,
the second active region is formed of a second semiconductor layer formed on the semiconductor substrate via a second buried insulating film,
the wiring includes a first wiring portion extending above the first active region along the first side of the semiconductor chip, a second wiring portion extending above the second active region along the second side of the semiconductor chip, and a rounded-shaped third wiring portion connecting one end of the first wiring portion and one end of the second wiring portion;
the first wiring portion and the first semiconductor layer of the first active region are connected via an opening formed in the interlayer insulating film, and
the second wiring portion and the second semiconductor layer of the second active region are connected via an opening formed in the interlayer insulating film.

11. The semiconductor device according to claim 10, further comprising a field limiting ring having a second conductive type that is different from the first conductive type, the field limiting ring being provided on the semiconductor substrate,
wherein the field limiting ring includes a first field limiting portion extending below the first active region along the first side of the semiconductor chip, a second field limiting portion below the second active region along the second side of the semiconductor chip, and a rounded-shaped third field limiting portion connecting one end of the first field limiting portion and one end of the second field limiting portion,
the first field limiting portion and the first semiconductor layer of the first active region are connected via an opening formed in the first buried insulating film, and
the second field limiting portion and the second semiconductor layer of the second active region are connected via an opening formed in the second buried insulating film.

12. The semiconductor device according to claim 11,
the wiring and the field limiting ring overlap each other in a planar view.

13. The semiconductor device according to claim 8, further comprising:
an interlayer insulating film formed on the first active region and the second active region; and
a wiring formed on the interlayer insulating film,
wherein the first active region includes a first semiconductor layer formed on a semiconductor substrate having a first conductive type via a first buried insulating film,
the second active region includes a second semiconductor layer formed on the semiconductor substrate via a second buried insulating film,
the wiring includes a first wiring portion extending above the first active region along the first side of the semiconductor chip, a second wiring portion extending above the second active region along the second side of the semiconductor chip, and a rounded-shaped third wiring portion connecting one end of the first wiring portion and one end of the second wiring portion,
in a planar view, one or two or more quadrangular-shaped third active regions including a third semiconductor layer formed on the semiconductor substrate via a third buried insulating film are arranged below the third wiring portion of the wiring,
the first wiring portion and the first semiconductor layer of the first active region are connected via an opening formed in the interlayer insulating film,
the second wiring portion and the second semiconductor layer of the second active region are connected via an opening formed in the interlayer insulating film, and
the third wiring portion and the third semiconductor layer of the third active region are connected via an opening formed in the interlayer insulating film.

14. The semiconductor device according to claim 13, further comprising a field limiting ring of a second conductive type that is different from the first conductive type, the field limiting ring being provided on the semiconductor substrate,
wherein the field limiting ring includes a first field limiting portion extending below the first active region along the first side of the semiconductor chip, a second field limiting portion below the second active region along the second side of the semiconductor chip, and a rounded-shaped third field limiting portion connecting one end of the first field limiting portion and one end of the second field limiting portion,
the first field limiting portion and the first semiconductor layer of the first active region are connected together via an opening formed in the first buried insulating film,
the second field limiting portion and the second semiconductor layer of the second active region are connected via an opening formed in the second buried insulating film, and
the third field limiting portion and the third semiconductor layer of the third active region are connected via an opening formed in the third buried insulating film.

15. The semiconductor device according to claim 14,
the wiring and the field limiting ring overlap each other in a planar view.
